(19) Europäisches Patentamt
European Patent Office
Office européen des brevets

(11) **EP 2 144 171 B1**

(12) **EUROPEAN PATENT SPECIFICATION**

(45) Date of publication and mention
of the grant of the patent:
**16.05.2018 Bulletin 2018/20**

(51) Int Cl.:
**G10L 19/02** (2013.01)     **G10L 19/08** (2013.01)
**G10L 19/20** (2013.01)

(21) Application number: **08017661.3**

(22) Date of filing: **08.10.2008**

(54) **Audio encoder and decoder for encoding and decoding frames of a sampled audio signal**

Audiokodierer und -dekodierer zur Kodierung und Dekodierung von Frames eines abgetasteten Audiosignals

Encodeur et décodeur audio pour coder et décoder des trames d'un signal audio échantillonné

(84) Designated Contracting States:
AT BE BG CH CY CZ DE DK EE ES FI FR GB GR HR HU IE IS IT LI LT LU LV MC MT NL NO PL PT RO SE SI SK TR

(30) Priority: **11.07.2008 US 79862 P**

(43) Date of publication of application:
**13.01.2010 Bulletin 2010/02**

(73) Proprietors:
• **Fraunhofer-Gesellschaft zur Förderung der angewandten Forschung e.V.**
**80686 München (DE)**
• **VoiceAge Corporation**
**Montreal QC H3R 2H6 (CA)**

(72) Inventors:
• **Geiger, Ralf**
**90409 Nuernberg (DE)**
• **Grill, Bernhard**
**91207 Lauf (DE)**
• **Bessette, Bruno**
**Sherbrooke, Quebec J1N 4G5 (CA)**
• **Gournay, Philippe**
**Sherbrooke, Quebec J1L 0A2 (CA)**
• **Fuchs, Guillaume**
**90409 Nuernberg (DE)**
• **Multrus, Markus**
**90469 Nuernberg (DE)**
• **Neuendorf, Max**
**90402 Nuernberg (DE)**
• **Schuller, Gerald**
**99089 Erfurt (DE)**

(74) Representative: **Zinkler, Franz et al**
**Schoppe, Zimmermann, Stöckeler**
**Zinkler, Schenk & Partner mbB**
**Patentanwälte**
**Radlkoferstrasse 2**
**81373 München (DE)**

(56) References cited:
**WO-A-2008/071353     US-A1- 2005 185 850**

• **BESSETTE B ET AL: "Universal Speech/Audio Coding Using Hybrid ACELP/TCX Techniques" ACOUSTICS, SPEECH, AND SIGNAL PROCESSING, 2005. PROCEEDINGS. (ICASSP '05). IEEE INTERNATIONAL CONFERENCE ON PHILADELPHIA, PENNSYLVANIA, USA MARCH 18-23, 2005, PISCATAWAY, NJ, USA,IEEE, vol. 3, 18 March 2005 (2005-03-18), pages 301-304, XP010792234 ISBN: 978-0-7803-8874-1**
• **JUIN-HWEY CHEN: "A candidate coder for the ITU-T's new wideband speech coding standard" ACOUSTICS, SPEECH, AND SIGNAL PROCESSING, 1997. ICASSP-97., 1997 IEEE INTERNATIONAL CONFERENCE ON MUNICH, GERMANY 21-24 APRIL 1997, LOS ALAMITOS, CA, USA,IEEE COMPUT. SOC, US, vol. 2, 21 April 1997 (1997-04-21), pages 1359-1362, XP010226055 Munich, Germany ISBN: 978-0-8186-7919-3**
• **RAMPRASHAD S A: "A MULTIMODE TRANSFORM PREDICTIVE CODER (MTPC) FOR SPEECH AND AUDIO" IEEE WORKSHOP ON SPEECH CODING PROCEEDINGS. MODEL, CODERS ANDERROR CRITERIA, XX, XX, 1 January 1999 (1999-01-01), pages 10-12, XP001010827**

• SCHNITZLER J ET AL: "Trends and perspectives in wideband speech coding" SIGNAL PROCESSING, ELSEVIER SCIENCE PUBLISHERS B.V. AMSTERDAM, NL, vol. 80, no. 11, 1 November 2000 (2000-11-01), pages 2267-2281, XP004218323 ISSN: 0165-1684

## Description

The present invention relates to source coding and particularly to audio source coding, in which an audio signal is processed by two different audio coders having different coding algorithms.

In the context of low bitrate audio and speech coding technology, several different coding techniques have traditionally been employed in order to achieve low bitrate coding of such signals with best possible subjective quality at a given bitrate. Coders for general music / sound signals aim at optimizing the subjective quality by shaping a spectral (and temporal) shape of the quantization error according to a masking threshold curve which is estimated from the input signal by means of a perceptual model ("perceptual audio coding"). On the other hand, coding of speech at very low bitrates has been shown to work very efficiently when it is based on a production model of human speech, i.e. employing Linear Predictive Coding (LPC) to model the resonant effects of the human vocal tract together with an efficient coding of the residual excitation signal.

As a consequence of these two different approaches, general audio coders, like MPEG-1 Layer 3 (MPEG = Moving Pictures Expert Group), or MPEG-2/4 Advanced Audio Coding (AAC) usually do not perform as well for speech signals at very low data rates as dedicated LPC-based speech coders due to the lack of exploitation of a speech source model. Conversely, LPC-based speech coders usually do not achieve convincing results when applied to general music signals because of their inability to flexibly shape the spectral envelope of the coding distortion according to a masking threshold curve. In the following, concepts are described which combine the advantages of both LPC-based coding and perceptual audio coding into a single framework and thus describe unified audio coding that is efficient for both general audio and speech signals.

Traditionally, perceptual audio coders use a filterbank-based approach to efficiently code audio signals and shape the quantization distortion according to an estimate of the masking curve.

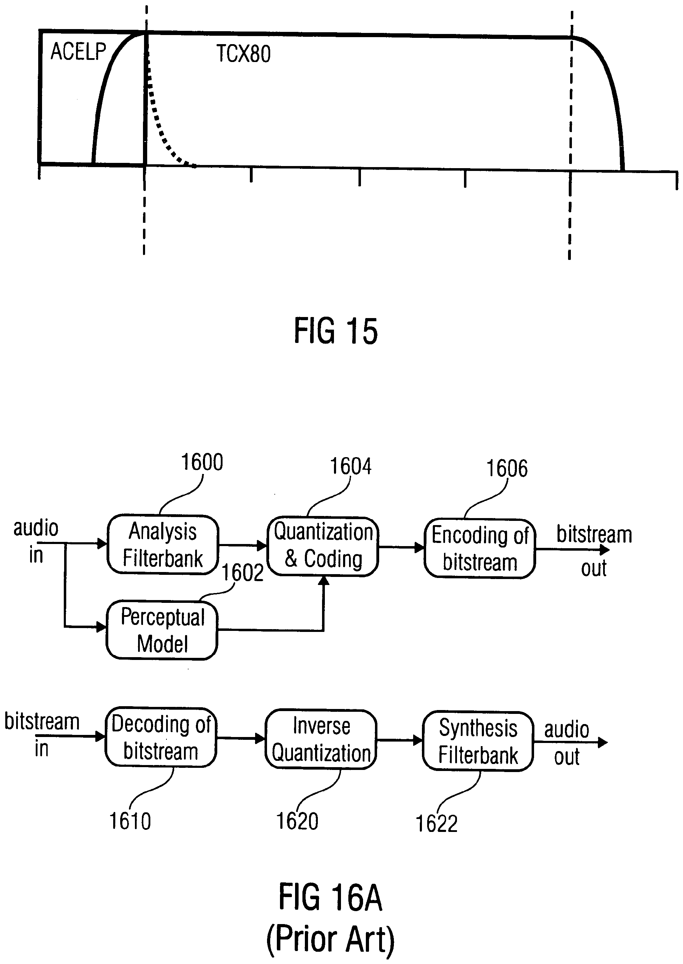

Fig. 16a shows the basic block diagram of a monophonic perceptual coding system. An analysis filterbank 1600 is used to map the time domain samples into subsampled spectral components. Dependent on the number of spectral components, the system is also referred to as a subband coder (small number of subbands, e.g. 32) or a transform coder (large number of frequency lines, e.g. 512). A perceptual ("psychoacoustic") model 1602 is used to estimate the actual time dependent masking threshold. The spectral ("subband" or "frequency domain") components are quantized and coded 1604 in such a way that the quantization noise is hidden under the actual transmitted signal, and is not perceptible after decoding. This is achieved by varying the granularity of quantization of the spectral values over time and frequency.

The quantized and entropy-encoded spectral coefficients or subband values are, in addition with side information, input into a bitstream formatter 1606, which provides an encoded audio signal which is suitable for being transmitted or stored. The output bitstream of block 1606 can be transmitted via the Internet or can be stored on any machine readable data carrier.

On the decoder-side, a decoder input interface 1610 receives the encoded bitstream. Block 1610 separates entropy-encoded and quantized spectral/subband values from side information. The encoded spectral values are input into an entropy-decoder such as a Huffman decoder, which is positioned between 1610 and 1620. The outputs of this entropy decoder are quantized spectral values. These quantized spectral values are input into a requantizer, which performs an "inverse" quantization as indicated at 1620 in Fig. 16a. The output of block 1620 is input into a synthesis filterbank 1622, which performs a synthesis filtering including a frequency/time transform and, typically, a time domain aliasing cancellation operation such as overlap and add and/or a synthesis-side windowing operation to finally obtain the output audio signal.

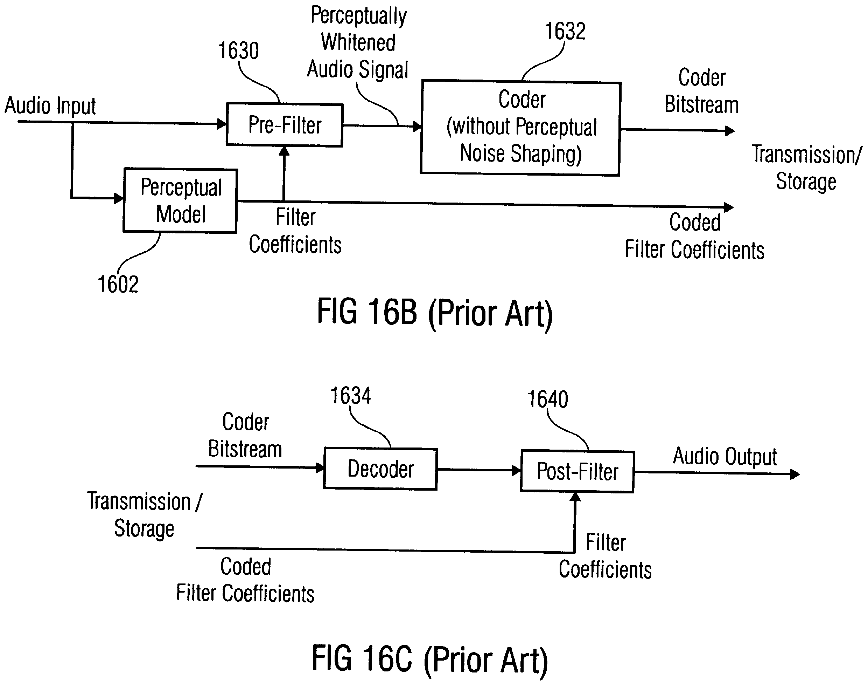

Figs. 16b, 16c indicate an alternative to the entire filter-bank based perceptual coding concept of Fig. 16a, in which a pre-filtering approach on the encoder-side and a post-filtering approach on the decoder-side are implemented.

In B. Edler, G. Schuller, "Audio coding using a psychoacoustic pre- and post-filter", ICASSP 2000, Volume 2, 5-9 June 2000 Page(s) II881 - II884 vol.2, the authors disclose a perceptual audio coder which separates the aspects of irrelevance reduction (i.e. noise shaping according to perceptual criteria) and redundancy reduction (i.e. obtaining a mathematically more compact representation of information) by using a so-called prefilter rather than a variable quantization of the spectral coefficients over frequency. The principle is illustrated in Fig. 16b. The input signal is analyzed by a perceptual model 1602 to compute an estimate of the masking threshold curve over frequency. The masking threshold is converted into a set of pre-filter coefficients such that the magnitude of its frequency response is inversely proportional to the masking threshold. The pre-filter operation applies this set of coefficients to the input signal, which produces an output signal in which all frequency components are represented according to their perceptual importance ("perceptual whitening"). This signal is subsequently coded by any kind of audio coder 1632, which produces a "white" quantization distortion, i.e. does not apply any perceptual noise shaping. The transmission / storage of the audio signal include both, the coder's bit-stream and a coded version of the pre-filtering coefficients. In the decoder of Fig. 16c, the coder bit-stream is decoded (1634) into the perceptually whitened audio signal, which contains additive white quantization noise. This signal is then subjected to a post-filtering operation 1640 according to the transmitted filter coefficients. Since the post-filter performs the inverse filtering process relative to the pre-filter, it reconstructs the original audio input signal from the perceptually whitened signal. The additive white quantization noise is spectrally shaped like the masking curve by the post-filter and thus appears perceptually colored at the decoder output, as intended.

Since in such a scheme perceptual noise shaping is achieved via the pre-/post-filtering step rather than frequency dependent quantization of spectral coefficients, the concept can be generalized to include non-filterbank-based coding mechanism for representing the pre-filtered audio signal rather than a filterbank-based audio coder. In G. Schuller, B. Yu, D. Huang, and B. Edler, "Perceptual Audio Coding using Adaptive Pre- and Post-Filters and Lossless Compression", IEEE Transactions on Speech and Audio Processing, September 2002, pp. 379-390, this is shown for time domain coding kernel using predictive and entropy coding stages.

In order to enable appropriate spectral noise shaping by using pre-/post-filtering techniques, it is important to adapt the frequency resolution of the pre-/post-filter to that of the human auditory system. Ideally, the frequency resolution would follow well-known perceptual frequency scales, such as the BARK or ERB frequency scale, cf. Zwicker, E. and H. Fastl, "Psychoacoustics, Facts and Models", Springer Verlag, Berlin. This is especially desirable in order to minimize the order of the pre-/post-filter model and thus the associated computational complexity and side information transmission rate.

The adaptation of the pre-/post-filter frequency resolution can be achieved by the well-known frequency warping concept, cf. M. Karjalainen, A. Härmä, U.K. Laine, "Realizable warped IIR filters and their properties", IEEE ICASSP 1997, pp. 2205 - 2208, vol.3. Essentially, the unit delays within a filter structure are replaced by (first or higher order) allpass filters, which leads to a non-uniform deformation ("warping") of the frequency response of the filter. It has been shown that even by using a first-order allpass filter, e.g.

$$\frac{z^{-1} - \lambda}{1 - \lambda z^{-1}},$$

a quite accurate approximation of perceptual frequency scales is possible by an appropriate choice of the allpass coefficients, cf. J.O. Smith, J.S. Abel, "Bark and ERB Bilinear Trans-forms", IEEE Transactions on Speech and Audio Processing, Volume 7, Issue 6, Nov. 1999, pp. 697 - 708. Thus, most known systems do not make use of higher- order allpass filters for frequency warping. Since a first-order allpass filter is fully determined by a single scalar parameter (which will be referred to as the "warping factor" $-1 < \lambda < 1$), which determines the deformation of the frequency scale. For example, for a warping factor of $\lambda = 0$, no deformation is effective, i.e. the filter operates on the regular frequency scale. The higher the warping factor is chosen, the more frequency resolution is focused on the lower frequency part of the spectrum (as it is necessary to approximate a perceptual frequency scale), and taken away from the higher frequency part of the spectrum.

Using a warped pre-/post-filter, audio coders typically use a filter order between 8 and 20 at common sampling rates like 48 kHz or 44.1 kHz S. Wabnik, G. Schuller, U. Krämer, J. Hirschfeld, "Frequency Warping in Low Delay Audio Coding", IEEE International Conference on Acoustics, Speech, and Signal Processing, March 18-23, 2005, Philadelphia, PA, USA.

Several other applications of warped filtering have been described, e.g. modeling of room impulse responses, cf. Härmä Aki, Karjalainen Matti, Savioja Lauri, Välimäki Vesa, Laine Unto K., Huopaniemi Jyri, "Frequency-Warped Signal Processing for Audio Applications", Journal of the AES, Volume 48 Number 11 pp. 1011-1031, November 2000 and parametric modeling of a noise component in the audio signal (under the equivalent name Laguerre / Kauz filtering), cf. E. Schuijers, W. Oomen, B. den Brinker, J. Breebaart, "Advances in Parametric Coding for High-Quality Audio", 114th Convention, Amsterdam, The Netherlands 2003, pre-print 5852.

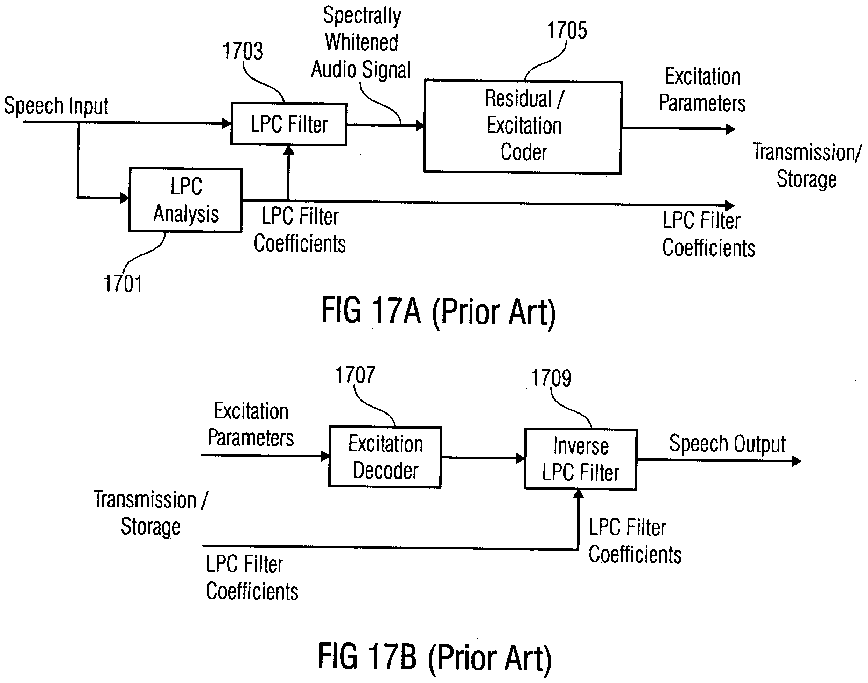

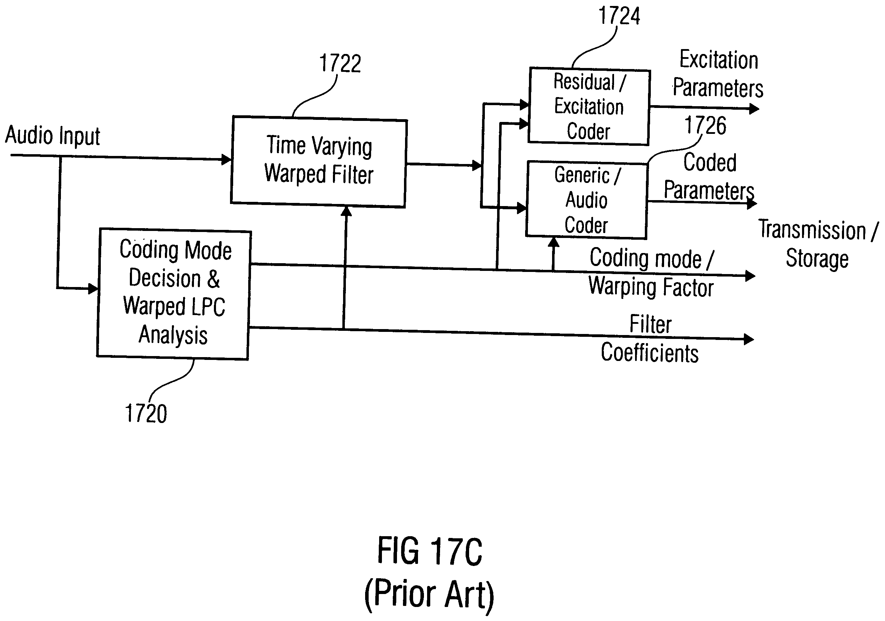

Traditionally, efficient speech coding has been based on Linear Predictive Coding (LPC) to model the resonant effects of the human vocal tract together with an efficient coding of the residual excitation signal. Both LPC and excitation parameters are transmitted from the encoder to the decoder. This principle is illustrated in Figs. 17a and 17b.

Fig. 17a indicates the encoder-side of an encoding/decoding system based on linear predictive coding. The speech input is input into an LPC analyzer 1701, which provides, at its output, LPC filter coefficients. Based on these LPC filter coefficients, an LPC filter 1703 is adjusted. The LPC filter outputs a spectrally whitened audio signal, which is also termed "prediction error signal". This spectrally whitened audio signal is input into a residual/excitation coder 1705, which generates excitation parameters. Thus, the speech input is encoded into excitation parameters on the one hand, and LPC coefficients on the other hand.

On the decoder-side illustrated in Fig. 17b, the excitation parameters are input into an excitation decoder 1707, which generates an excitation signal, which can be input into an inverse LPC filter. The inverse LPC filter is adjusted using the transmitted LPC filter coefficients. Thus, the inverse LPC filter 1709 generates a reconstructed or synthesized speech output signal.

Over time, many methods have been proposed with respect to an efficient and perceptually convincing representation of the residual (excitation) signal, such as Multi-Pulse Excitation (MPE), Regular Pulse Excitation (RPE), and Code-Excited Linear Prediction (CELP).

Linear Predictive Coding attempts to produce an estimate of the current sample value of a sequence based on the observation of a certain number of past values as a linear combination of the past observations. In order to reduce redundancy in the input signal, the encoder LPC filter "whitens" the input signal in its spectral envelope, i.e. it is a model of the inverse of the signal's spectral envelope. Conversely, the decoder LPC filter is a model of the signal's spectral envelope. Specifically, the well-known auto-regressive (AR) linear predictive analysis is known to model the signal's spectral envelope by means of an all-pole approximation.

Typically, narrow band speech coders (i.e. speech coders with a sampling rate of 8kHz) employ an LPC filter with an order between 8 and 12. Due to the nature of the LPC filter, a uniform frequency resolution is effective across the full frequency range. This does not correspond to a perceptual frequency scale.

Noticing that a non-uniform frequency sensitivity, as it is offered by warping techniques, may offer advantages also for speech coding, there have been proposals to substitute the regular LPC analysis by warped predictive analysis, e.g. K. Tokuda, H. Matsumura, T. Kobayashi and S. Imai, "Speech coding based on adaptive melcepstral analysis," Proc. IEEE ICASSP'94, pp.197-200, Apr. 1994 or K. Koishida, K. Tokuda, T. Kobayashi and S. Imai, "CELP coding based on melcepstral analysis," Proc. IEEE ICASSP'95, pp.33-36, 1995. Other combinations of warped LPC and CELP coding are known, e.g. from Aki Härmä, Unto K. Laine, Matti Karjalainen, "Warped low-delay CELP for wideband audio coding", 17th International AES Conference, Florence, Italy, 1999.

In order to combine the strengths of traditional LPC/CELP-based coding (best quality for speech signals) and the traditional filterbank-based perceptual audio coding approach (best for music), a combined coding between these architectures has been proposed. In the AMR-WB+ (AMR-WB = Adaptive Multi-Rate WideBand) coder B. Bessette, R. Lefebvre, R. Salami, "UNIVERSAL SPEECH/AUDIO CODING USING HYBRID ACELP/TCX TECHNIQUES," Proc. IEEE ICASSP 2005, pp. 301 - 304, 2005 two alternate coding kernels operate on an LPC residual signal. One is based on ACELP (ACELP = Algebraic Code Excited Linear Prediction) and thus is extremely efficient for coding of speech signals. The other coding kernel is based on TCX (TCX = Transform Coded Excitation), i.e. a filterbank based coding approach resembling the traditional audio coding techniques in order to achieve good quality for music signals. Depending on the characteristics of the input signal signals, one of the two coding modes is selected for a short period of time to transmit the LPC residual signal. In this way, frames of 80ms duration can be split into subframes of 40ms or 20ms in which a decision between the two coding modes is made.

The AMR-WB+ (AMR-WB+ = extended Adaptive Multi-Rate WideBand codec), cf. 3GPP (3GPP = Third Generation Partnership Project) technical specification number 26.290, version 6.3.0, June 2005, can switch between the two essentially different modes ACELP and TCX. In the ACELP mode a time domain signal is coded by algebraic code excitation. In the TCX mode a fast Fourier transform (FFT = fast Fourier transform) is used and the spectral values of the excitation signal are coded based on vector quantization.

The decision, which modes to use, can be taken by trying and decoding both options and comparing the resulting signal-to-noise ratios (SNR = Signal-to-Noise Ratio).

This case is also called the closed loop decision, as there is a closed control loop, evaluating both coding performances and/or efficiencies, respectively, and then choosing the one with the better SNR by discarding the other. AMR-WB+ does also have an open loop decision mode, where based on decision criteria, as e.g. certain signal properties as transience, a decision on whether to use ACELP or TCX is predetermined.

It is well-known that for audio and speech coding applications a block transform without windowing is not feasible. Therefore, for the TCX mode the signal is windowed with a low overlap window with an overlap of $1/8^{th}$. This overlapping region is necessary, in order to fade-out a prior block or frame while fading-in the next, for example to suppress artifacts due to uncorrelated quantization noise in consecutive audio frames. This way the overhead compared to non-critical sampling is kept reasonably low and the decoding necessary for the closed-loop decision reconstructs at least $7/8^{th}$ of the samples of the current frame.

The AMR-WB+ introduces $1/8^{th}$ of overhead in a TCX mode, i.e. the number of spectral values to be coded is $1/8^{th}$ higher than the number of input samples. This provides the disadvantage of an increased data overhead. Moreover, the frequency response of the corresponding band pass filters is disadvantageous, due to the steep overlap region of $1/8^{th}$ of consecutive frames.

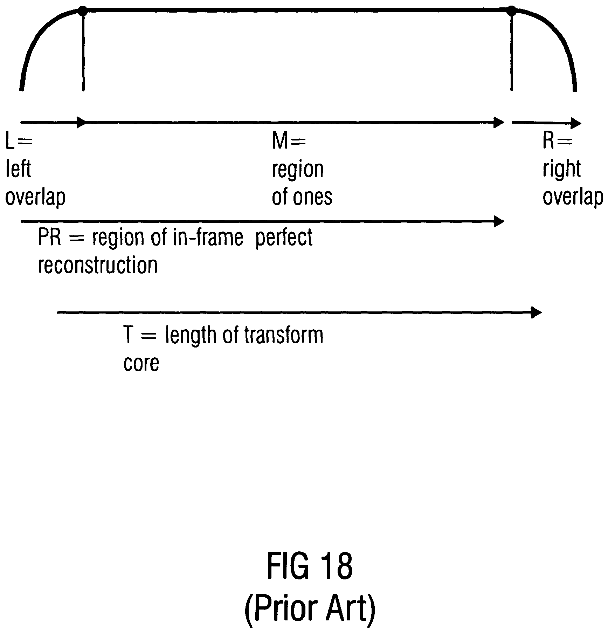

In order to elaborate more on the code overhead and overlap of consecutive frames, Fig. 18 illustrates a definition of window parameters. The window shown in Fig. 18 has a rising edge part on the left-hand side, which is denoted with "L" and also called left overlap region, a center region which is denoted by "M", which is also called a region of 1 or bypass part, and a falling edge part, which is denoted by "R" and also called the right overlap region. Moreover, Fig. 18 shows an arrow indicating the region "PR" of perfect reconstruction within a frame. Furthermore, Fig. 18 shows an arrow indicating the length of the transform core, which is denoted by "T".

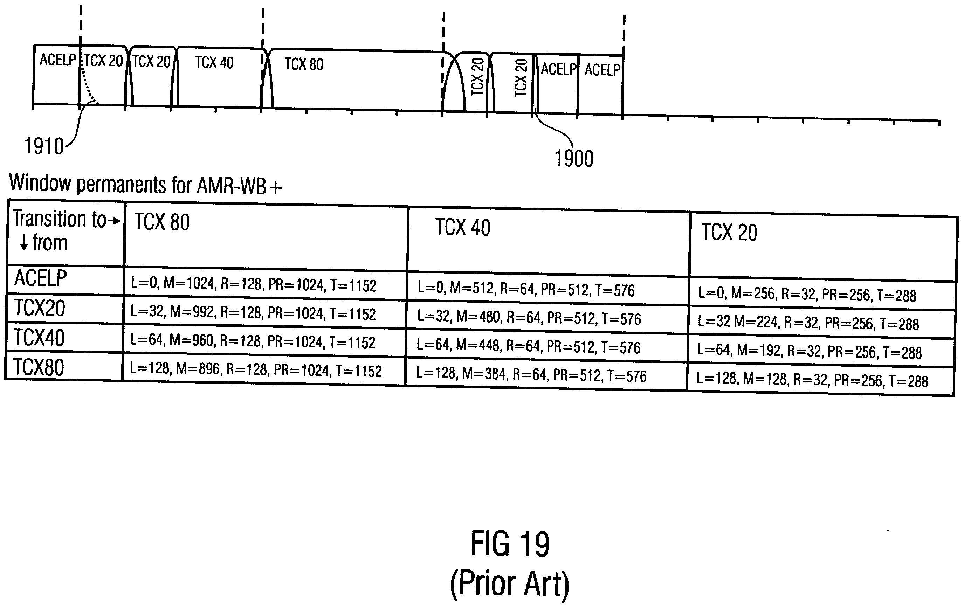

Fig. 19 shows a view graph of a sequence of AMR-WB+ windows and at the bottom a table of window parameter according to Fig. 18. The sequence of windows shown at the top of Fig. 19 is ACELP, TCX20 (for a frame of 20ms duration), TCX20, TCX40 (for a frame of 40ms duration), TCX80 (for a frame of 80ms duration), TCX20, TCX20, ACELP, ACELP.

From the sequence of windows the varying overlapping regions can be seen, which overlap by exact $1/8^{th}$ of the center part M. The table at the bottom of Fig.

19 also shows that the transform length "T" is always by 1/8th larger than the region of new perfectly reconstructed samples "PR". Moreover, it is to be noted that this is not only the case for ACELP to TCX transitions, but also for TCXx to TCXx (where "x" indicates TCX frames of arbitrary length) transitions. Thus, in each block an overhead of 1/8th is introduced, i.e. critical sampling is never achieved.

When switching from TCX to ACELP the window samples are discarded from the FFT-TCX frame in the overlapping region, as for example indicated at the top of Fig. 19 by the region labeled with 1900. When switching from ACELP to TCX the zero-input response (ZIR = zero-input response), which is also indicated by the dotted line 1910 at the top of Fig. 19, is removed at the encoder for windowing and added at the decoder for recovering. When switching from TCX to TCX frames the windowed samples are used for cross-fade. Since the TCX frames can be quantized differently quantization error or quantization noise between consecutive frames can be different and/or independent. Therewith, when switching from one frame to the next without cross-fade, noticeable artifacts may occur, and hence, cross-fade is necessary in order to achieve a certain quality.

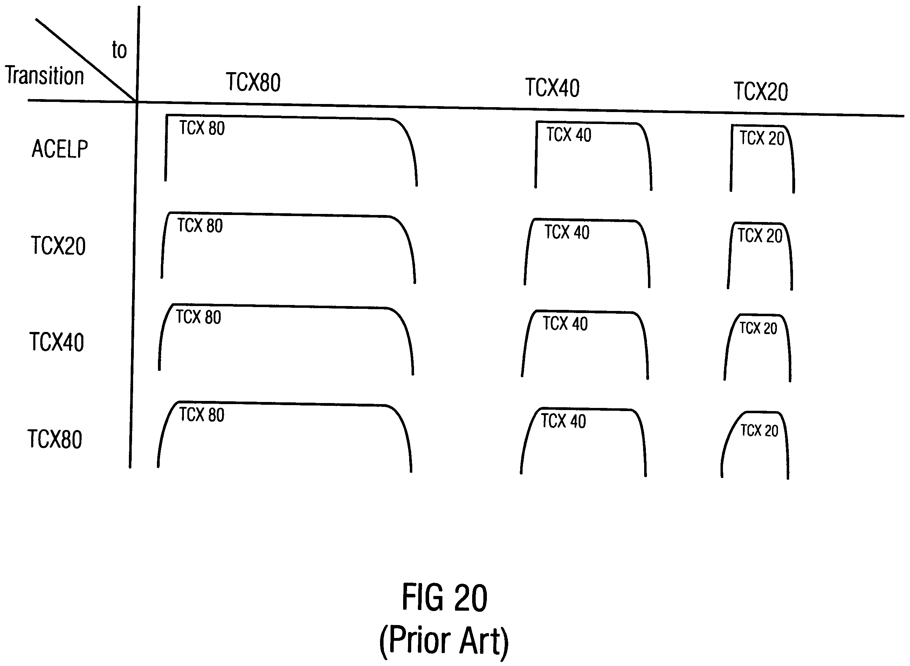

From the table at the bottom of Fig. 19 it can be seen, that the cross-fade region grows with a growing length of the frame. Fig. 20 provides another table with illustrations of the different windows for the possible transitions in AMR-WB+. When transiting from TCX to ACELP the overlapping samples can be discarded. When transiting from ACELP to TCX, the zero-input response from the ACELP can be removed at the decoder and added the decoder for recovering.

It is a significant disadvantage of the AMR-WB+ that an overhead of 1/8th is always introduced.

The technical publication "A Multimode Transform Predictive Coder (MTPC)for Speech and Audio", S.A. Ramprashad, IEEE workshop on speech coding proceedings, module, coders and error criteria, 1999, pages 10-12, discloses that speech coders work better on speech and audio coders perform better on music. In order to merge the two technologies into a single coding paradigm, a multimode speech and audio coder is disclosed that can adapt almost continuously between a speech and audio coding mode. The encoder has, as mode 1, a speech mode being primarily used for signal segments with rapidly changing spectra. At mode 3 or audio mode is used for signals which have slow varying spectra, slowly varying subframe signal energies and that have moderate to high LP coding gains. Signals targeted by this mode include music and vocal sequences. A further mode 2a,b,c or transitional mode is used for signals with low long-term prediction gains and rapidly changing spectra or subframe signal energies. Signals with low LP coding gains are also used for in this mode. Mode 2 consists of three main sub-modes and is used for unvoiced speech segments, background noise and transient segments in music.

It is the object of the present invention to provide a more efficient concept for audio encoding.

The object is achieved by an audio encoder according to claim 1, a method for audio encoding according to claim 11, an audio decoder according to claim 13 and a method for audio decoding according to claim 19.

Embodiments of the present invention are based on the finding that a more efficient coding can be carried out, if time-aliasing introducing transforms are used, for example, for TCX encoding. Time aliasing introducing transforms can allow achieving critical sampling while still being able to cross-fade between adjacent frames. For example in one embodiment the modified discrete cosine transform (MDCT = Modified Discrete Cosine Transform) is used for transforming overlapping time domain frames to the frequency domain. Since this particular transform produces only N frequency domain samples for 2N time domain samples, critical sampling can be maintained even though the time domain frames may overlap by 50%. At the decoder or the inverse time-aliasing introducing transform an overlap and add stage may be adapted for combining the time aliased overlapping and back transformed time domain samples in a way, that time domain aliasing cancelation (TDAC = Time Domain Aliasing Cancelation) can be carried out.

Embodiments may be used in the context of a switched frequency domain and time domain coding with low overlap windows, such as for example the AMR-WB+. Embodiments may use an MDCT instead of a non-critically sampled filterbank. In this way the overhead due to non-critical sampling may be advantageously reduced based on the critical sampling property of, for example, the MDCT. Additionally, longer overlaps are possible without introducing additional overhead. Embodiments can provide the advantage that based on the longer overheads, crossover-fading can be carried out more smoothly, in other words, sound quality may be increased at the decoder.

In one detailed embodiment the FFT in the AMR-WB+ TCX-mode may be replaced by an MDCT while keeping functionalities of AMR-WB+, especially the switching between the ACELP mode and the TCX mode based on a closed or open loop decision. Embodiments may use the MDCT in a non-critically sampled fashion for the first TCX frame after an ACELP frame and subsequently use the MDCT in a critically sampled fashion for all subsequent TCX frames. Embodiments may retain the feature of closed loop decision, using the MDCT with low overlap windows similar to the unmodified AMR-WB+, but with longer overlaps. This may provide the advantage of a better frequency response compared to the unmodified TCX windows.

Embodiments of the present invention will be detailed using the accompanying figures, in which:

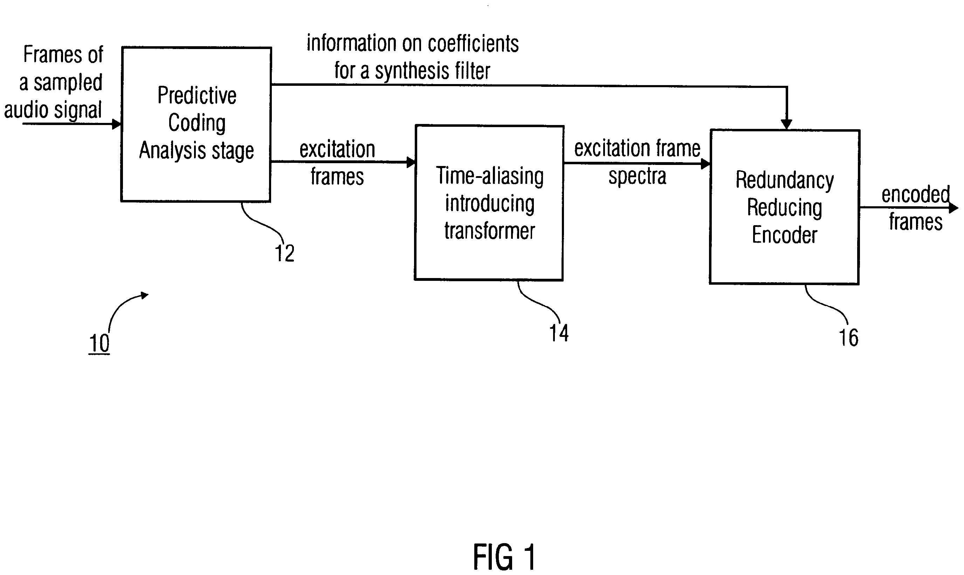

Fig. 1          shows an embodiment of an audio encoder;

| Figs. 2a-2j | show equations for an embodiment of a time domain aliasing introducing transform; |
|---|---|
| Fig. 3a | shows another embodiment of an audio encoder; |
| Fig. 3b | shows another embodiment of an audio encoder; |
| Fig. 3c | shows yet another embodiment of an audio encoder; |
| Fig. 3d | shows yet another embodiment of an audio encoder; |
| Fig. 4a | shows a sample of time domain speech signal for voice speech; |
| Fig. 4b | illustrates a spectrum of a voiced speech signal sample; |
| Fig. 5a | illustrates a time domain signal of a sample of a unvoiced speech; |
| Fig. 5b | shows a spectrum of a sample of an unvoiced speech signal; |
| Fig. 6 | shows an embodiment of an analysis-by-synthesis CELP; |
| Figs. 7a-7d | illustrate voiced/unvoiced excitation signals as an example for impulse-like and stationary signals; |
| Fig. 7e | illustrates an encoder-side ACELP stage providing short-term prediction information and a prediction error signal; |
| Fig. 8a | shows an embodiment of an audio decoder; |
| Fig. 8b | shows another embodiment of an audio decoder; |
| Fig. 8c | shows another embodiment of an audio decoder; |
| Fig. 9 | shows an embodiment of a window function; |
| Fig. 10 | shows another embodiment of a window function; |
| Fig. 11 | shows view graphs and delay charts of prior art window functions and a window function of an embodiment; |
| Fig. 12 | illustrates window parameters; |
| Fig. 13a | shows a sequence of window functions and an according to table of window parameters; |
| Fig. 13b | shows possible transitions for an MDCT-based embodiment; |
| Fig. 14a | shows a table of possible transitions in an embodiment; |
| Fig. 14b | illustrates a transition window from ACELP to TCX80 according to one embodiment; |
| Fig. 14c | shows an embodiment of a transition window from a TCXx frame to a TCX20 frame to a TCXx frame according to one embodiment; |
| Fig. 14d | illustrates an embodiment of a transition window from ACELP to TCX20 according to one embodiment; |
| Fig. 14e | shows an embodiment of a transition window from ACELP to TCX40 according to one embodiment; |
| Fig. 14f | illustrates an embodiment of the transition window for a transition from a TCXx frame to a TCX80 frame to a TCXx frame according to one embodiment; |
| Fig. 15 | illustrates an ACELP to TCX80 transition according to one embodiment; |
| Figs. | 16a-16c illustrate conventional encoder and decoder examples; |
| Figs. 17a-17c | illustrate LPC for voiced and unvoiced signals; |
| Fig. 18 | illustrates a prior art cross-fade window; |
| Fig. 19 | illustrates a prior art sequence of AMR-WB+ windows; |
| Fig. 20 | illustrates windows used for transmitting in AMR-WB+ between ACELP and TCX. |

In the following, embodiments of the present invention will be described in detail. It is to be noted, that the following embodiments shall not limit the scope of the invention, they shall be rather taken as possible realizations or implementations among many different embodiments.

Fig. 1a shows an audio encoder 10 adapted for encoding frames of a sampled audio signal to obtain encoded frames, wherein a frame comprises a number of time domain audio samples, the audio encoder 10 comprises a predictive coding analysis stage 12 for determining information on coefficients for a synthesis filter and an excitation frame based on frames of audio samples, the excitation frame comprising samples of an excitation signal for the synthesis filter.

The audio encoder 10 further comprises a time-aliasing introducing transformer 14 for transforming overlapping excitation frames to the frequency domain to obtain excitation frame spectra, wherein the time-aliasing introducing transformer 14 is adapted to transforming the overlapping excitation frames in a critically sampled way. The audio encoder 10 further comprises a redundancy reducing encoder 16 for encoding the excitation frame spectra to obtain the encoded frames based on the coefficients and the encoded excitation frame spectra.

The redundancy reducing encoder 16 may be adapted for using Huffman coding or entropy coding in order to encode the excitation frame spectra and/or the information on the coefficients.

In embodiments the time-aliasing introducing transformer 14 can be adapted for transforming overlapping excitation frames such that an average number of samples of an excitation frame spectrum equals an average number of samples in an excitation frame, thereby achieving the critically sampled transform. Furthermore, the time-aliasing introducing transformer 14 can be adapted for transforming overlapping excitation frames according to a modified discrete cosine transformation (MDCT = Modified Discrete Cosine Transform).

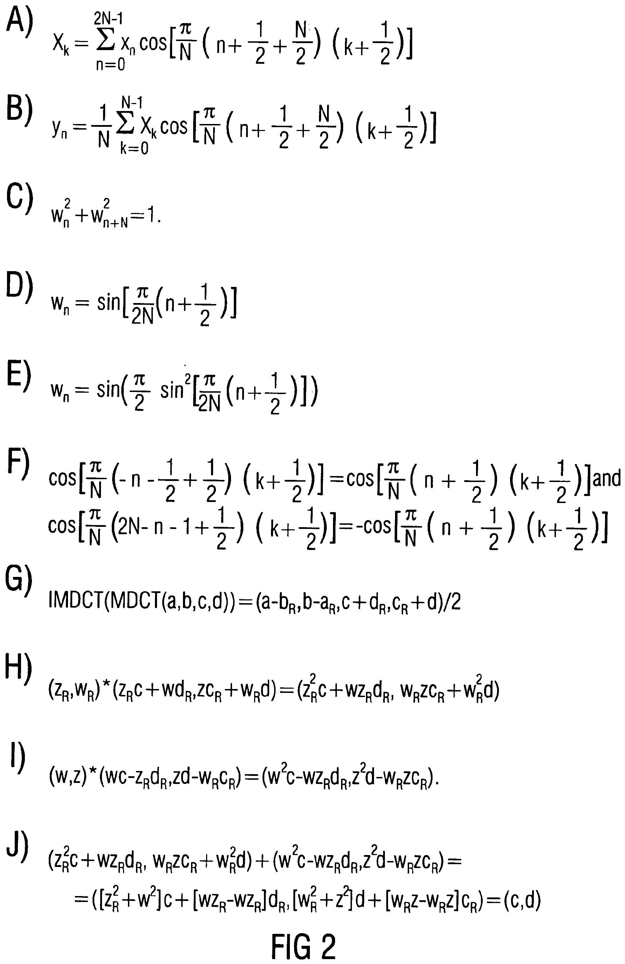

In the following, the MDCT will be explained in further detail with the help of the equations illustrated in Figs. 2a-2j. The modified discrete cosine transform (MDCT) is a Fourier-related transform based on the type-IV discrete cosine transform (DCT-IV = Discrete Cosine Transform type IV), with the additional property of being lapped, i.e. it is designed to be performed on consecutive blocks of a larger dataset, where subsequent blocks are overlapped so that e.g. the last half of one block coincides with the first half of the next block. This overlapping, in addition to the energy-compaction qualities of the DCT, makes the MDCT especially attractive for signal compression applications, since it helps to avoid artifacts stemming from the block boundaries. Thus, an MDCT is employed in MP3 (MP3 = MPEG2/4 layer 3), AC-3 (AC-3 = Audio Codec 3 by Dolby), Ogg Vorbis, and AAC (AAC = Advanced Audio Coding) for audio compression, for example.

The MDCT was proposed by Princen, Johnson, and Bradley in 1987, following earlier (1986) work by Princen and Bradley to develop the MDCT's underlying principle of time-domain aliasing cancellation (TDAC), further described below. There also exists an analogous transform, the MDST, based on the discrete sine transform, as well as other, rarely used, forms of the MDCT based on different types of DCT or DCT/DST (DST = Discrete Sine Tranform) combinations, which can also be used in embodiments by the time domain aliasing introducing transform 14.

In MP3, the MDCT is not applied to the audio signal directly, but rather to the output of a 32-band polyphase quadrature filter (PQF = Polyphase Quadrature Filter) bank. The output of this MDCT is postprocessed by an alias reduction formula to reduce the typical aliasing of the PQF filter bank. Such a combination of a filter bank with an MDCT is called a hybrid filter bank or a subband MDCT. AAC, on the other hand, normally uses a pure MDCT; only the (rarely used) MPEG-4 AAC-SSR variant (by Sony) uses a four-band PQF bank followed by an MDCT. ATRAC (ATRAC = Adaptive TRansform Audio Coding) uses stacked quadrature mirror filters (QMF) followed by an MDCT.

As a lapped transform, the MDCT is a bit unusual compared to other Fourier-related transforms in that it has half as many outputs as inputs (instead of the same number). In particular, it is a linear function $F : \mathbf{R}^{2N} \rightarrow \mathbf{R}^N$, where $\mathbf{R}$ denotes the set of real numbers. The 2N real numbers $x_0, ..., x_{2N-1}$ are transformed into the N real numbers $X_0, ..., X_{N-1}$ according to the formula in Fig. 2a.

The normalization coefficient in front of this transform, here unity, is an arbitrary convention and differs between treatments. Only the product of the normalizations of the MDCT and the IMDCT, below, is constrained.

The inverse MDCT is known as the IMDCT. Because there are different numbers of inputs and outputs, at first glance it might seem that the MDCT should not be invertible. However, perfect invertibility is achieved by adding the overlapped IMDCTs of subsequent overlapping blocks, causing the errors to cancel and the original data to be retrieved; this technique is known as time-domain aliasing cancellation (TDAC).

The IMDCT transforms N real numbers $X_0, ..., X_{N-1}$ into 2N real numbers $y_0, ..., y_{2N-1}$ according to the formula in Fig. 2b. Like for the DCT-IV, an orthogonal transform, the inverse has the same form as the forward transform.

In the case of a windowed MDCT with the usual window normalization (see below), the normalization coefficient in front of the IMDCT should be multiplied by 2 i.e., becoming 2/N.

Although the direct application of the MDCT formula would require $O(N^2)$ operations, it is possible to compute the same thing with only O(N log N) complexity by recursively factorizing the computation, as in the fast Fourier transform (FFT). One can also compute MDCTs via other transforms, typically a DFT (FFT) or a DCT, combined with O(N) pre- and post-processing steps. Also, as described below, any algorithm for the DCT-IV immediately provides a method to compute the MDCT and IMDCT of even size.

In typical signal-compression applications, the transform properties are further improved by using a window function $w_n$ (n = 0, ..., 2N-1) that is multiplied with $x_n$ and $y_n$ in the MDCT and IMDCT formulas, above, in order to avoid discontinuities at the n = 0 and 2N boundaries by making the function go smoothly to zero at those points. That is, the data is windowed before the MDCT and after the IMDCT. In principle, x and y could have different window functions, and the window function could also change from one block to the next, especially for the case where data blocks of different sizes are combined, but for simplicity the common case of identical window functions for equal-sized blocks is considered first.

The transform remains invertible, i.e. TDAC works, for a symmetric window $w_n = w_{2N-1-n}$, as long as w satisfies the Princen-Bradley condition according to Fig. 2c.

Various different window functions are common, an example is given in Fig. 2d for MP3 and MPEG-2 AAC, and in Fig. 2e for Vorbis. AC-3 uses a Kaiser-Bessel derived (KBD = Kaiser-Bessel derived) window, and MPEG-4 AAC can also use a KBD window.

Note that windows applied to the MDCT are different from windows used for other types of signal analysis, since they must fulfill the Princen-Bradley condition. One of the reasons for this difference is that MDCT windows are applied twice, for both the MDCT (analysis filter) and the IMDCT (synthesis filter).

As can be seen by inspection of the definitions, for even N the MDCT is essentially equivalent to a DCT-IV, where the input is shifted by N/2 and two N-blocks of data are transformed at once. By examining this equivalence more carefully, important properties like TDAC can be easily derived.

In order to define the precise relationship to the DCT-IV, one must realize that the DCT-IV corresponds to alternating even/odd boundary conditions, it is even at its left boundary (around n=-1/2), odd at its right boundary (around n=N-1/2), and so on (instead of periodic boundaries as for a DFT). This follows from the identities given in Fig. 2f. Thus, if its inputs are an array x of length N, imagine extending this array to (x, -x_R, -x, x_R, ...) and so on can be imagined, where $x_R$ denotes x in reverse order.

Consider an MDCT with 2N inputs and N outputs, where the inputs can be divided into four blocks (a, b, c, d) each of size N/2. If these are shifted by N/2 (from the +N/2 term in the MDCT definition), then (b, c, d) extend past the end of the N DCT-IV inputs, so they must be "folded" back according to the boundary conditions described above.

Thus, the MDCT of 2N inputs (a, b, c, d) is exactly equivalent to a DCT-IV of the N inputs: (-c_R-d, a-b_R), where R denotes reversal as above. In this way, any algorithm to compute the DCT-IV can be trivially applied to the MDCT.

Similarly, the IMDCT formula as mentioned above is precisely 1/2 of the DCT-IV (which is its own inverse), where the output is shifted by N/2 and extended (via the boundary conditions) to a length 2N. The inverse DCT-IV would simply give back the inputs (-c_R-d, a-b_R) from above. When this is shifted and extended via the boundary conditions, one obtains the result displayed in Fig. 2g. Half of the IMDCT outputs are thus redundant.

One can now understand how TDAC works. Suppose that one computes the MDCT of the subsequent, 50% overlapped, 2N block (c, d, e, f). The IMDCT will then yield, analogous to the above: (c-d_R, d-c_R, e+f_R, e_R+f) / 2. When this is added with the previous IMDCT result in the overlapping half, the reversed terms cancel and one obtains simply (c, d), recovering the original data.

The origin of the term "time-domain aliasing cancellation" is now clear. The use of input data that extend beyond the boundaries of the logical DCT-IV causes the data to be aliased in exactly the same way that frequencies beyond the Nyquist frequency are aliased to lower frequencies, except that this aliasing occurs in the time domain instead of the frequency domain. Hence the combinations c-d_R and so on, which have precisely the right signs for the combinations to cancel when they are added.

For odd N (which are rarely used in practice), N/2 is not an integer so the MDCT is not simply a shift permutation of a DCT-IV. In this case, the additional shift by half a sample means that the MDCT/IMDCT becomes equivalent to the DCT-III/II, and the analysis is analogous to the above.

Above, the TDAC property was proved for the ordinary MDCT, showing that adding IMDCTs of subsequent blocks in their overlapping half recovers the original data. The derivation of this inverse property for the windowed MDCT is only slightly more complicated.

Recall from above that when (a,b,c,d) and (c,d,e,f) are MDCTed, IMDCTed, and added in their overlapping half, we obtain (c + d_R,c_R + d) / 2 + (c - d_R,d - c_R) / 2 = (c,d), the original data.

Now, multiplying both the MDCT inputs and the IMDCT outputs by a window function of length 2N is supposed. As above, we assume a symmetric window function, which is therefore of the form (w,z,z_R,w_R), where w and z are length-N/2 vectors and R denotes reversal as before. Then the Princen-Bradley condition can be written

$$w^2 + z_R^2 = (1, 1, \ldots),$$

with the multiplications and additions performed elementwise, or equivalently

$$w_R^2 + z^2 = (1, 1, \ldots)$$

reversing w and z.

Therefore, instead of MDCTing (a,b,c,d), MDCT (wa,zb,$z_R$c,$w_R$d) is MDCTed with all multiplications performed elementwise. When this is IMDCTed and multiplied again (elementwise) by the window function, the last-N half results as displayed in Fig. 2h.

Note that the multiplication by ½ is no longer present, because the IMDCT normalization differs by a factor of 2 in the windowed case. Similarly, the windowed MDCT and IMDCT of (c,d,e,f) yields, in its first-N half according to Fig. 2i. When these two halves are added together, the results of Fig. 2j are obtained, recovering the original data.

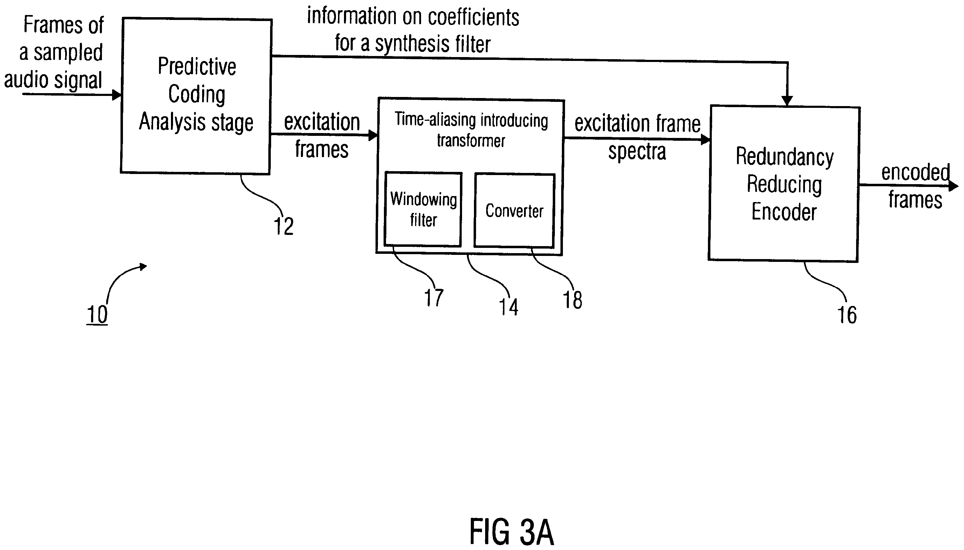

Fig. 3a depicts another example of the audio coder 10. In the embodiment depicted in Fig. 3a the time-aliasing introducing transformer 14 comprises a windowing filter 17 for applying a windowing function to overlapping excitation frames and a converter 18 for converting windowed overlapping excitation frames to the excitation frame spectra. According to the above multiple window functions are conceivable, some of which will be detailed further below.

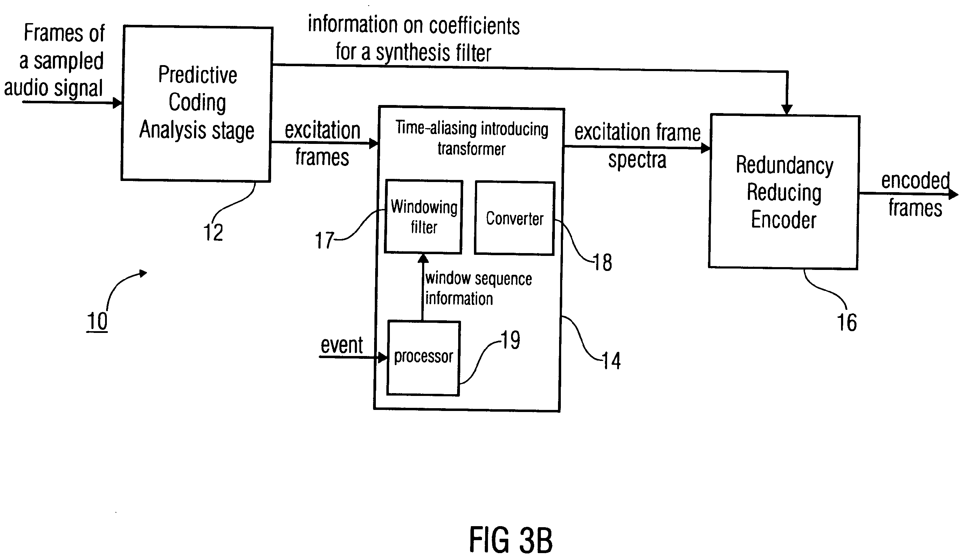

Another example of an audio encoder 10 is depicted in Fig. 3b. In the embodiment depicted in Fig. 3b the time-aliasing introducing transformer 14 comprises a processor 19 for detecting an event and for providing a window sequence information if the event is detected and wherein the windowing filter 17 is adapted for applying the windowing function according to the window sequence information. For example, the event may occur dependent on certain signal properties analyzed from the frames of the sampled audio signal. For example different window length or different window edges etc. may be applied according to for example autocorrelation properties of the signal, tonality, transience, etc. In other words, different events may occur as part of different properties of the frames of the sampled audio signal, and the processor 19 may provide a sequence of different windows in dependence on the properties of the frames of the audio signal. More detailed sequences and parameters for window sequences will be set out below.

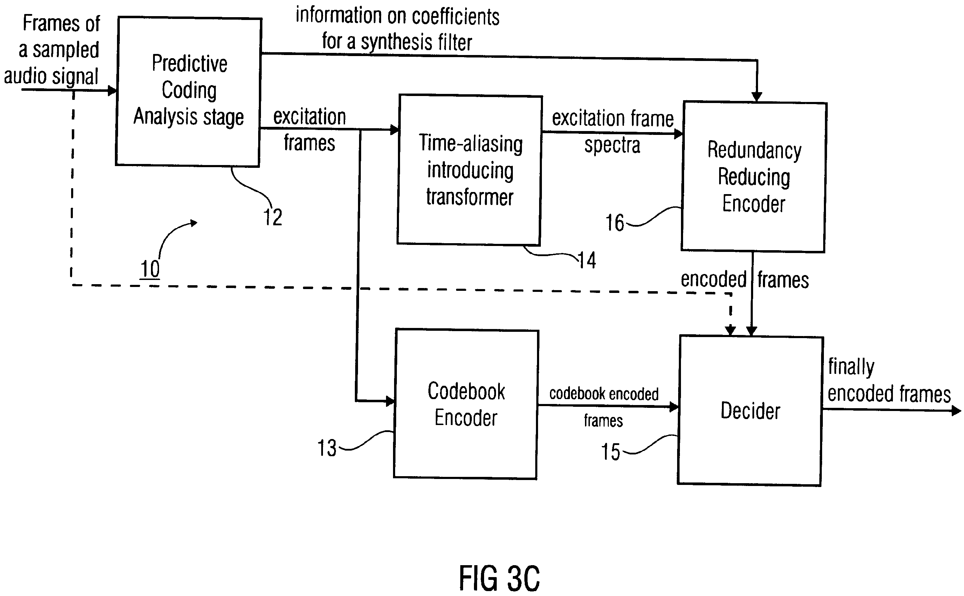

Fig. 3c shows an embodiment of an audio encoder 10. In the embodiment depicted in Fig. 3c the excitation frames are not only provided to the time-aliasing introducing transformer 14 but also to a codebook encoder 13, which is adapted for encoding the excitation frames based on a predetermined codebook to obtain a codebook encoded excitation frame. Moreover, the embodiment depicted in Fig. 3c comprises a decider for deciding whether to use a codebook encoded excitation frame or encoded frame to obtain a finally encoded frame based on a coding efficiency measure. The embodiment depicted in Fig. 3c may also be called a closed loop scenario. In this scenario the decider 15 has the possibility, to obtain encoded frames from two branches, one branch being transformation based the other branch being codebook based. In order to determine a coding efficiency measure, the decider may decode the encoded frames from both branches, and then determine the coding efficiency measure by evaluating error statistics from the different branches.

In other words, the decider 15 may be adapted for reverting the encoding procedure, i.e. carrying out full decoding for both branches. Having fully decoded frames the decider 15 may be adapted for comparing the decoded samples to the original samples, which is indicated by the dotted arrow in Fig. 3c. In the embodiment shown in Fig. 3c the decider 15 is also provided with the excitation frames, therewith it is enabled to decode encoded frames from the redundancy reducing encoder 16 and also decode codebook encoded frames from the codebook encoder 13 and compare the results to the originally encoded excitation frames. Therewith, in one embodiment by comparing the differences, coding efficiency measures for example in terms of a signal-to-noise ratio or a statistical error or minimum error, etc. can be determined, in some embodiments also in relation to the respective code rate, i.e. the number of bits required to encode the frames. The decider 15 can then be adapted for selecting either encoded frames from the redundancy reducing encoder 16 or the codebook encoded frames as finally encoded frames, based on the coding efficiency measure.

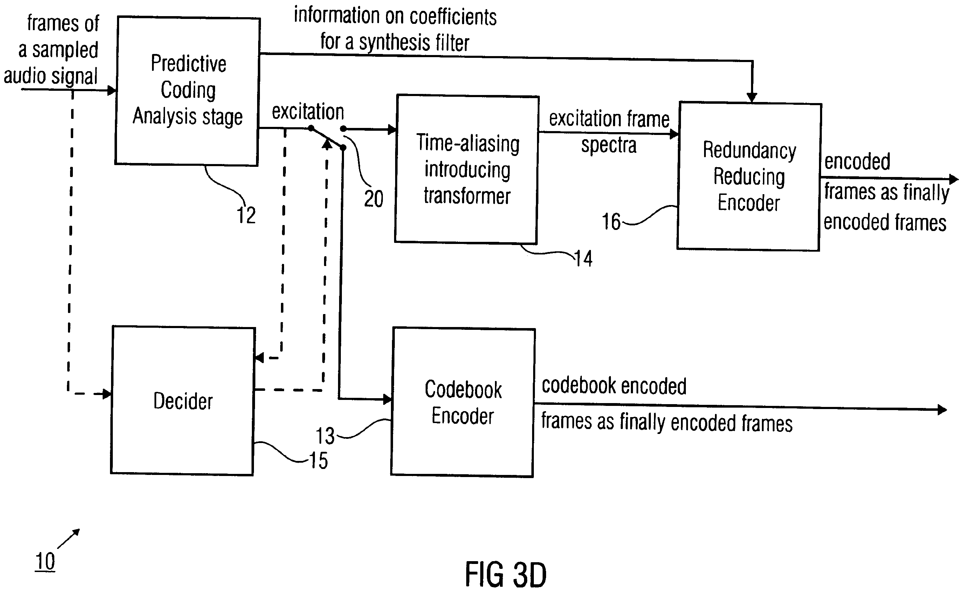

Fig. 3d shows another embodiment of the audio encoder 10. In the embodiment shown in Fig. 3d there is a switch 20 coupled to the decider 15 for switching the excitation frames between the time-aliasing introducing transformer 14 and the codebook encoder 13 based on a coding efficiency measure. The decider 15 can be adapted for determining a coding efficiency measure based on the frames of the sampled audio signal, in order to determine the position of the switch 20, i.e. whether to use the transform-based coding branch with the time-aliasing introducing transformer 14 and the redundancy reducing encoder 16 or the codebook based encoding branch with the codebook encoder 13. As already mentioned above, the coding efficiency measure may be determined based on properties of the frames of the sampled audio signal, i.e. the audio properties themselves, for example whether the frame is more tone-like or noise-like.

The configuration of the embodiment shown in Fig. 3d is also called open loop configuration, since the decider 15 may decide based on the input frames without knowing the results of the outcome of the respective coding branch. In yet another embodiment the decider may decide based on the excitation frames, which is shown in Fig. 3d by the dotted arrow. In other words, in one embodiment, the decider 15 may not decide based on the frames of the sampled audio signal, but rather on the excitation frames.

In the following, the decision process of the decider 15 is illuminated. Generally, a differentiation between an impulse-like portion of an audio signal and a stationary portion of a stationary signal can be made by applying a signal processing operation, in which the impulse-like characteristic is measured and the stationary-like characteristic is measured as well. Such measurements can, for example, be done by analyzing the waveform of the audio signal. To this end, any transform-based processing or LPC processing or any other processing can be performed. An intuitive way for determining as to whether the portion is impulse-like or not is for example to look at a time domain waveform and to determine whether this time domain waveform has peaks at regular or irregular intervals, and peaks in regular intervals are even more suited for a speech-like coder, i.e. for the codebook encoder. Note, that even within speech voiced and unvoiced parts can be distinguished. The codebook encoder 13 may be more efficient for voiced signal parts or voiced frames, wherein the transform-based branch comprising the time-aliasing introducing transformer 14 and the redundancy reducing encoder 16 may be more suitable for unvoiced frames.

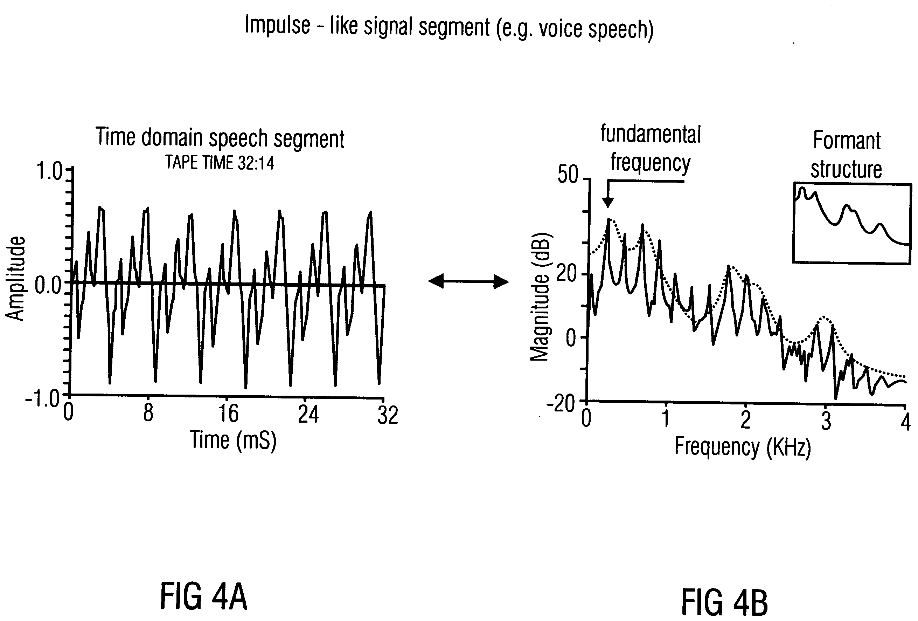

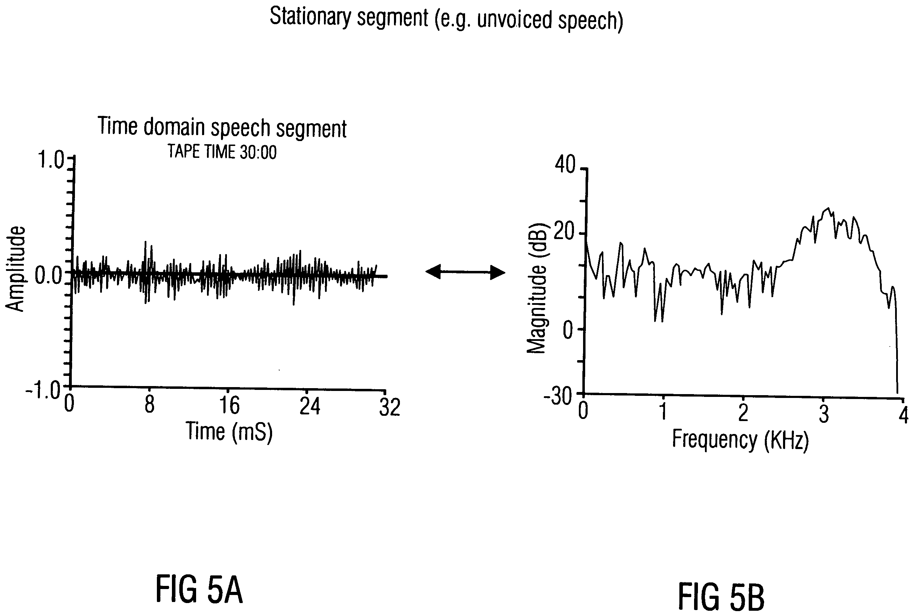

Exemplarily, reference is made to Figs. 4a and 4b, 5a and 5b, respectively. Impulse-like signal segments or signal portions and stationary signal segments or signal portions are exemplarily discussed. Generally, the decider 15 can be adapted for deciding based on different criteria, as e.g. stationarity, transience, spectral whiteness, etc. IN the following an example criteria is given as part of an embodiment. Specifically, a voiced speech is illustrated in Fig. 4a in the time domain and in Fig. 4b in the frequency domain and is discussed as example for an impulse-like signal portion, and an unvoiced speech segment as an example for a stationary signal portion is discussed in connection with Figs. 5a and 5b.

Speech can generally be classified as voiced, unvoiced or mixed. Time-and-frequency domain plots for sampled voiced and unvoiced segments are shown in Figs. 4a, 4b, 5a and 5b. Voiced speech is quasi periodic in the time domain and harmonically structured in the frequency domain, while unvoiced speech is random-like and broadband. In addition, the energy of voiced segments is generally higher than the energy of unvoiced segments. The short-term spectrum of voiced speech is characterized by its fine and formant structure. The fine harmonic structure is a consequence of the quasi-periodicity of speech and may be attributed to the vibrating vocal cords. The formant structure, which is also called the spectral envelope, is due to the interaction of the source and the vocal tracts. The vocal tracts consist of the pharynx and the mouth cavity. The shape of the spectral envelope that "fits" the short-term spectrum of voiced speech is associated with the transfer characteristics of the vocal tract and the spectral tilt (6 dB/octave) due to the glottal pulse.

The spectral envelope is characterized by a set of peaks, which are called formants. The formants are the resonant modes of the vocal tract. For the average vocal tract there are 3 to 5 formants below 5 kHz. The amplitudes and locations of the first three formants, usually occurring below 3 kHz are quite important, both, in speech synthesis and perception. Higher formants are also important for wideband and unvoiced speech representations. The properties of speech are related to physical speech production systems as follows. Exciting the vocal tract with quasi-periodic glottal air pulses generated by the vibrating vocal cords produces voiced speech. The frequency of the periodic pulse is referred to as the fundamental frequency or pitch. Forcing air through a constriction in the vocal tract produces unvoiced speech. Nasal sounds are due to the acoustic coupling of the nasal tract to the vocal tract, and plosive sounds are reduced by abruptly reducing the air pressure, which was built up behind the closure in the tract.

Thus, a stationary portion of the audio signal can be a stationary portion in the time domain as illustrated in Fig. 5a or a stationary portion in the frequency domain, which is different from the impulse-like portion as illustrated for example in Fig. 4a, due to the fact that the stationary portion in the time domain does not show permanent repeating pulses. As will be outlined later on, however, the differentiation between stationary portions and impulse-like portions can also be performed using LPC methods, which model the vocal tract and the excitation of the vocal tracts. When the frequency domain of the signal is considered, impulse-like signals show the prominent appearance of the individual formants, i.e., prominent peaks in Fig. 4b, while the stationary spectrum has quite a wide spectrum as illustrated in Fig. 5b, or in the case of harmonic signals, quite a continuous noise floor having some prominent peaks representing specific tones which occur, for example, in a music signal, but which do not have such a regular distance from each other as the impulse-like signal in Fig. 4b.

Furthermore, impulse-like portions and stationary portions can occur in a timely manner, i.e., which means that a portion of the audio signal in time is stationary and another portion of the audio signal in time is impulse-like. Alternatively or additionally, the characteristics of a signal can be different in different frequency bands. Thus, the determination, whether the audio signal is stationary or impulse-like, can also be performed frequency-selective so that a certain frequency band or several certain frequency bands are considered to be stationary and other frequency bands are considered to be impulse-like. In this case, a certain time portion of the audio signal might include an impulse-like portion or a stationary portion.

Coming back to the embodiment shown in Fig. 3d, the decider 15 may analyze the audio frames or the excitation signal, in order to determine whether they are rather impulse-like, i.e. more suitable for the codebook encoder 13, or stationary, i.e. more suitable for the transform-based encoding branch.

An efficient impulse coder usually quantizes both individual values and the positions of the impulses. One option for a mixed open/closed loop mode is to use the quantized impulse values and the accurate/unquantized impulse positions for calculating the residual signal. The impulse position is then quantized in an open-loop fashion. Alternatively, an iterative CELP (CELP = Code Excited Linear Prediction) analysis-by-synthesis process for the detection of impulse-like signals can be used, but a dedicated coding tool for the actual coding of the impulse signal is implemented, which quantizes or not, the position of the pulses with a small quantization error.

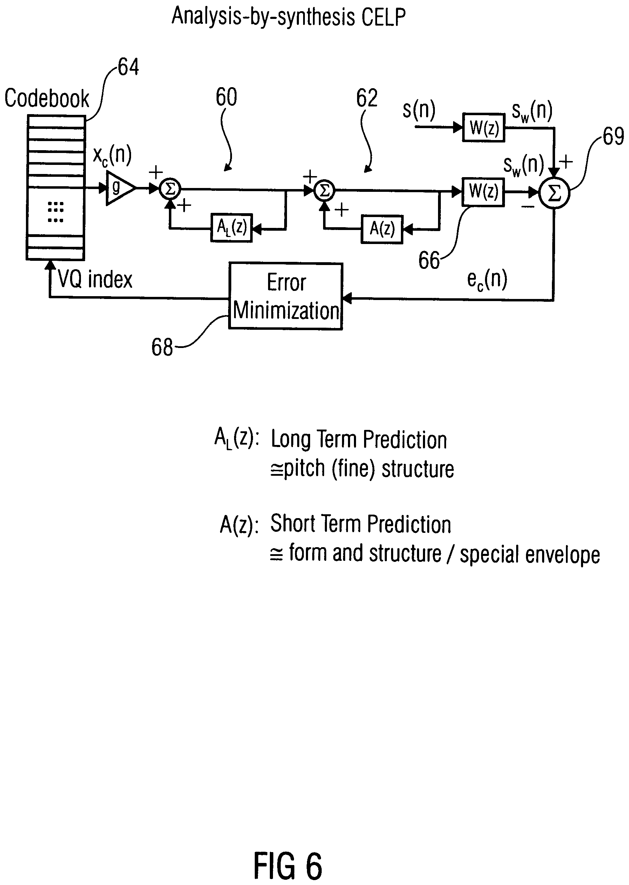

Subsequently, an analysis-by-synthesis CELP encoder will be discussed with respect to Fig. 6. Details of a CELP encoder can be also found in "Speech Coding: A tutorial review", Andreas Spaniers, Proceedings of IEEE, Vol. 84, No. 10, October 1994, pp. 1541-1582. The CELP encoder as illustrated in Fig. 6 includes a long-term prediction component 60 and a short-term prediction component 62. Furthermore, a codebook is used which is indicated at 64. A perceptual weighting filter W(z) is implemented at 66, and an error minimization controller is provided at 68. s(n) is the excitation signal, as for example, generated by the LPC analysis stage 12. This signal, i.e. the excitation frames, may also be called "prediction error signal" as will be illuminated and further detailed below. After having been perceptually weighted, the weighted prediction error signal is input into a subtractor 69, which calculates the error between the synthesis signal and the output of block 66 and the actual weighted prediction error signal $s_w(n)$.

Generally, the short-term prediction A(z) is calculated by a LPC analysis stage which will be further discussed below. Depending on this information, the long-term prediction information $A_L(z)$ including the long-term prediction gain g and the vector quantization index, i.e., codebook references can be calculated. The CELP algorithm encodes the excitation using a codebook of for example Gaussian sequences. The ACELP algorithm, where the "A" stands for "algebraic" has a specific algebraically designed codebook.

The codebook may contain more or less vectors where each vector has a length according to a number of samples. A gain factor g scales the excitation vector and the excitation samples are filtered by the long-term synthesis filter and a short-term synthesis filter. The "optimum" vector is selected such that the perceptually weighted mean square error is minimized. The search process in CELP is evident from the analysis-by-synthesis scheme illustrated in Fig. 6. It is to be noted, that Fig. 6 only illustrates an example of an analysis-by-synthesis CELP and that embodiments shall not be limited to the structure shown in Fig. 6.

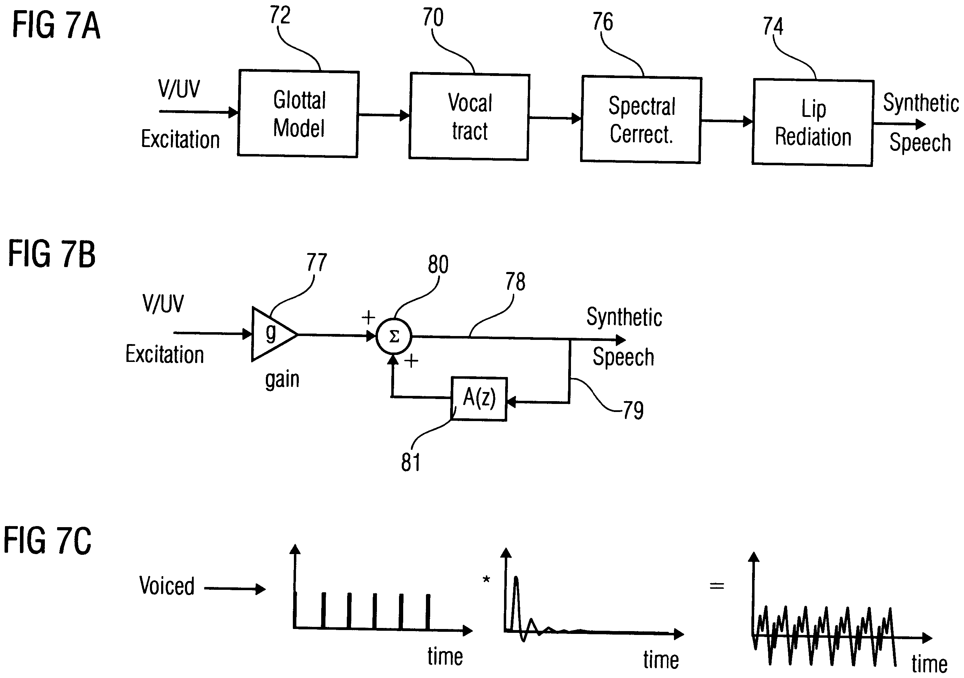

The functionality of an embodiment of the predictive coding analysis stage 12 will be discussed subsequently according to the embodiment shown in Figs. 7a to 7e, using LPC analysis and LPC synthesis in the decider 15, in the according embodiments.

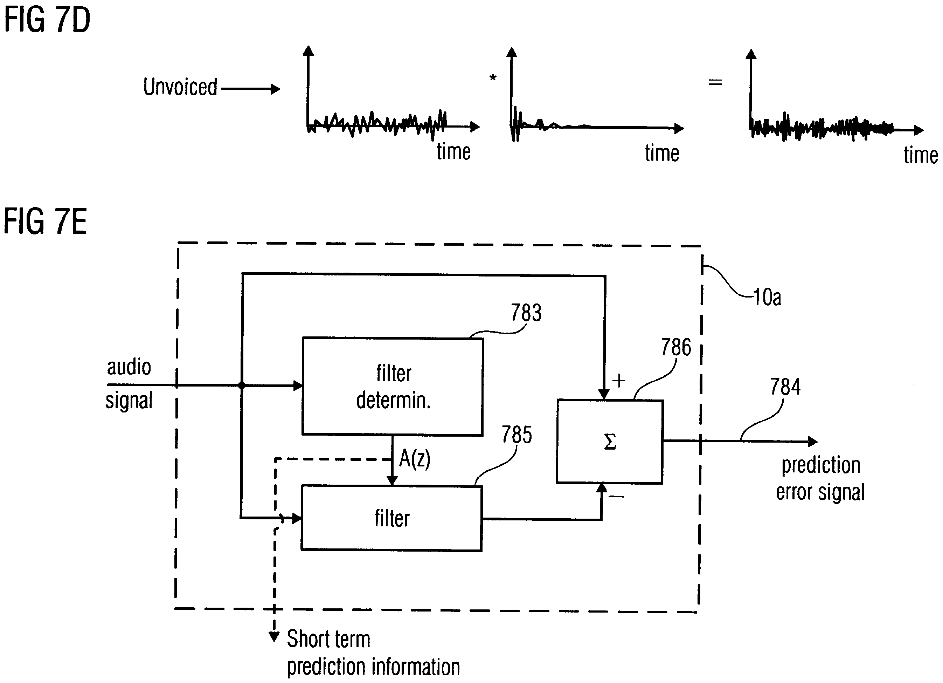

Fig. 7a illustrates a model of a linear speech prediction system. The system assumes a two-stage excitation, i.e., an impulse-frame for voiced speech as indicated in Fig. 7c and a random noise for unvoiced speech as indicated in Fig. 7d. The vocal tract is modeled as an all-pole transform filter 70, which processes pulses of Figs. 7c or 7d, generated by a glottal model 72. A cascade of a small number of two-pole resonators representing the formants forms the all-pole transfer function. The glottal model is represented as a two-pole low-pass filter, and the lip-radiation model 74 is represented by $L(z) = 1 - z^{-1}$.

Finally, a spectral correction factor 76 is included to compensate for the low-frequency effects of the higher poles. In individual speech representations the spectral correction is omitted and the zero of the lip-radiation function is essentially canceled by one of the glottal poles. Hence, the system of Fig. 7a can be reduced to an all-pole model of Fig. 7b having a gain stage 77, a forward pass 78, a feedback pass 79 and an adding stage 80. In the feedback pass 79, there is a prediction filter 81, and the whole source system synthesis model illustrated in Fig. 7b temporally represented using a z-domain function as follows:

$$S(z) = g/(1-A(z)) \cdot X(z),$$

where g represents the gain, A(z) is the prediction filter as determined by an LPC analysis, X(z) is the excitation signal, and S(z) is the synthesis speech output. Figs. 7c and 7d illustrate a graphical time domain description of voiced and unvoiced speech synthesis using the linear source system model. This system and the excitation parameters in the above equation are unknown and can be determined from a finite set of speech samples. The coefficients of A(z) are obtained using linear prediction.

In a p-th order forward linear predictor, the present sample of the speech sequence is predicted from a linear combination of t passed samples. Well-known algorithms such as the Levinson-Durbin algorithm, or generally an autocorrelation method or a reflection method can determine the predictor coefficients.

Fig. 7e illustrates a more detailed implementation of the embodiment of the LPC analysis block 12. The audio signal is input into a filter determination block, which determines the filter information A(z), i.e. the information on coefficients for the synthesis filter. This information is output as the short-term prediction information required for the decoder. The short-term prediction information might be required for the impulse coder output signal. Then, however, only the prediction error signal, shown at line 784 is required, the short-term prediction information does not have to be output. Nevertheless, the actual prediction filter 785 requires the short-term prediction information. In a subtractor 786, a current sample of the output signal is input and a predicted value for the current sample is subtracted so that for this sample, the prediction error signal is generated at line 784. Note that the prediction error signal may also be called excitation signal or excitation frame.

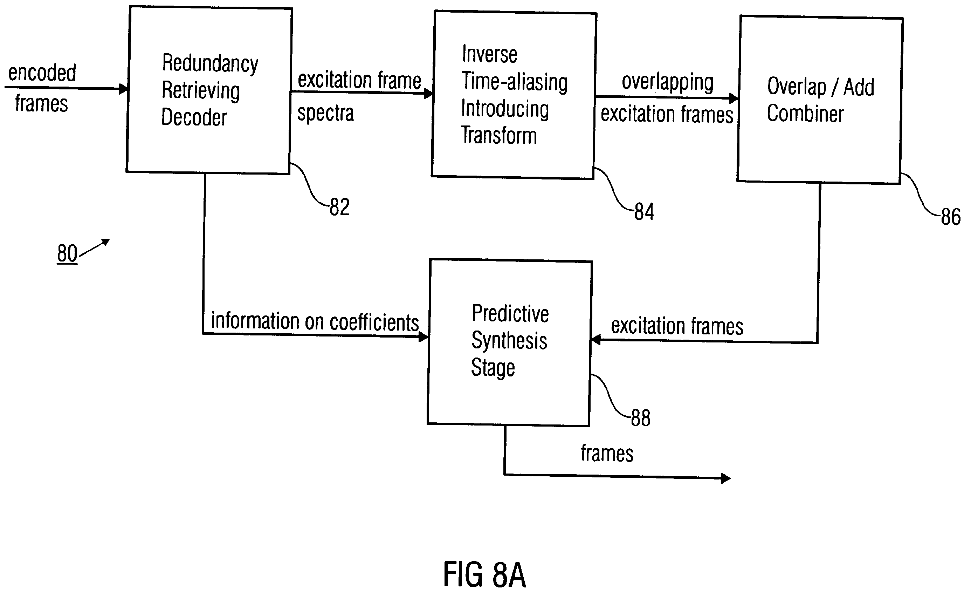

An example of an audio decoder 80 for decoding encoded frames to obtain frames of a sampled audio signal, wherein a frame comprises a number of time domain samples, is shown in Fig. 8a. The audio decoder 80 comprises a redundancy retrieving decoder 82 for decoding the encoded frames to obtain information on coefficients for a synthesis filter and excitation frame spectra. The audio decoder 80 further comprises an inverse time-aliasing introducing transformer 84 for transforming the excitation frame spectra to the time domain to obtain overlapping excitation frames, wherein the inverse time-aliasing introducing transformer 84 is adapted for determining overlapping excitation frames from consecutive excitation frame spectra. Moreover, the audio decoder 80 comprises an overlap/add combiner 86 for combining overlapping excitation frames to obtain an excitation frame in a critically-sampled way. The audio decoder 80 further comprises a predictive synthesis stage 88 for determining the frame based on the coefficients and the excitation frame.

The overlap and add combiner 86 can be adapted for combining overlapping excitation frames such that an average number of samples in an excitation frame equals an average number of samples of the excitation frame spectrum. In embodiments the inverse time-aliasing introducing transformer 84 can be adapted for transforming the excitation frame spectra to the time domain according to an IMDCT, according to the above details.

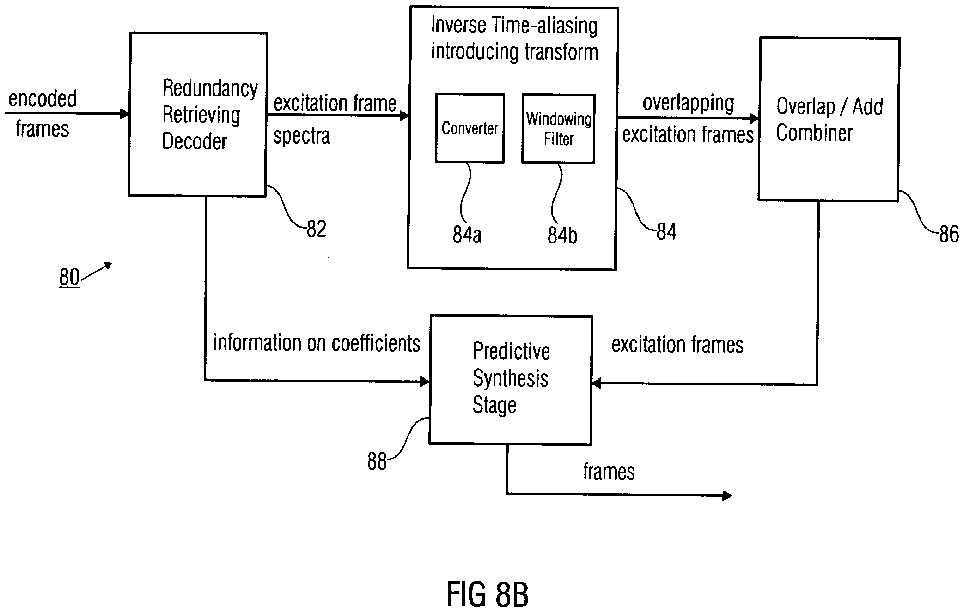

Moreover, in embodiments, the predictive synthesis stage 88 can be adapted for determining the frame based on linear prediction, i.e. LPC. Another example of an audio decoder 80 is depicted in Fig. 8b. The audio decoder 80 depicted in Fig. 8b shows similar components as the audio decoder 80 depicted in Fig. 8a, however, the inverse time-aliasing introducing transformer 84 in the example shown in Fig. 8b further comprises a converter 84a for converting excitation frame spectra to converted overlapping excitation frames and a windowing filter 84b for applying a windowing function to the converted overlapping excitation frames to obtain the overlapping excitation frames.

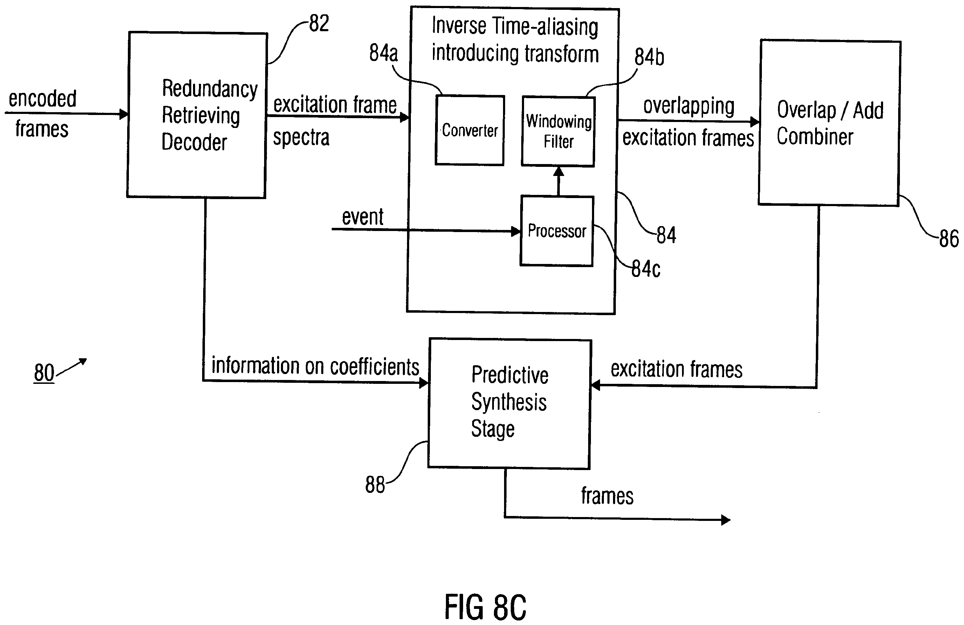

Fig. 8c shows an embodiment of an audio decoder 80 having similar components as in the embodiment depicted in Fig. 8b. In the embodiment depicted in Fig. 8c the inverse time-aliasing introducing transformer 84 further comprises a processor 84c for detecting an event and for providing a window sequence information if the event is detected to the windowing filter 84b and the windowing filter 84b is adapted for applying the windowing function according to the window sequence information. The event may be an indication derived from or provided by the encoded frames or any side information.

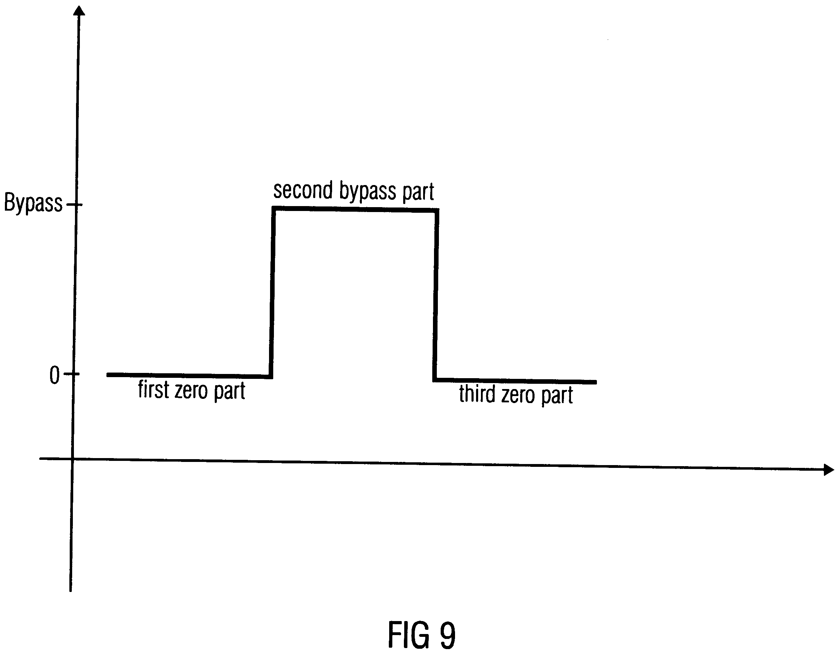

In embodiments of audio encoders 10 and audio decoders 80, the respective windowing filters 17 and 84 can be adapted for applying windowing functions according to window sequence information. Fig. 9 depicts a general rectangular window, in which the window sequence information may comprise a first zero part, in which the window masks samples, a second bypass part, in which the samples of a frame, i.e. an excitation frame or an overlapping excitation frame, may be passed through unmodified, and a third zero part, which again masks samples at the end of a frame. In other words, windowing functions may be applied, which suppress a number of samples of a frame in a first zero part, pass through samples in a second bypass part, and then suppress samples at the end of a frame in a third zero part. In this context suppressing may also refer to appending a sequence of zeros at the beginning and/or end of the bypass part of the window. The second bypass part may be such, that the windowing function simply has a value of 1, i.e. the samples are passed through unmodified, i.e. the windowing function switches through the samples of the frame.

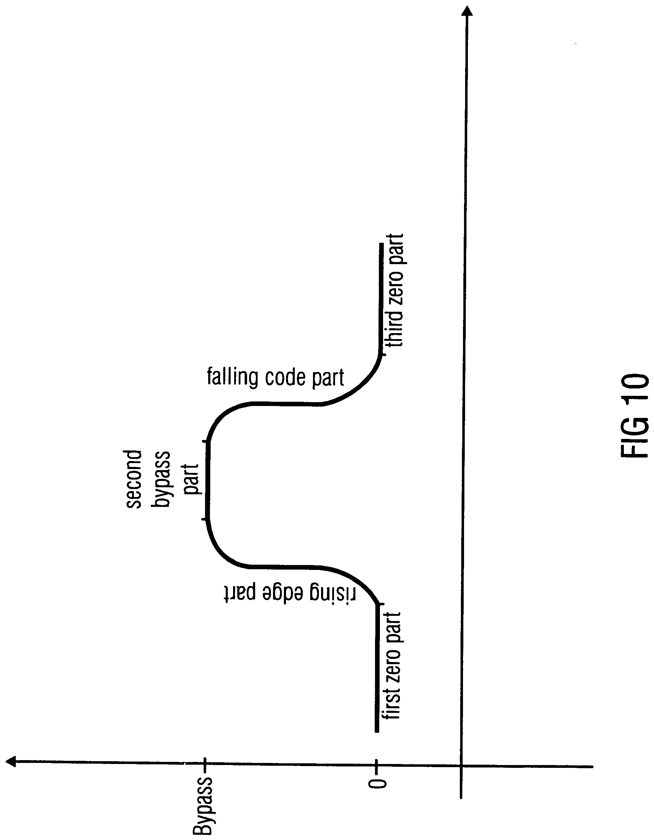

Fig. 10 shows another embodiment of a windowing sequence or windowing function, wherein the windowing sequence further comprises a rising edge part between the first zero part and the second bypass part and a falling edge part between the second bypass part and the third zero part. The rising edge part can also be considered as a fade-in part and the falling edge part can be considered as a fade-out part. In embodiments, the second bypass part may comprise a sequence of ones for not modifying the samples of the excitation frame at all.

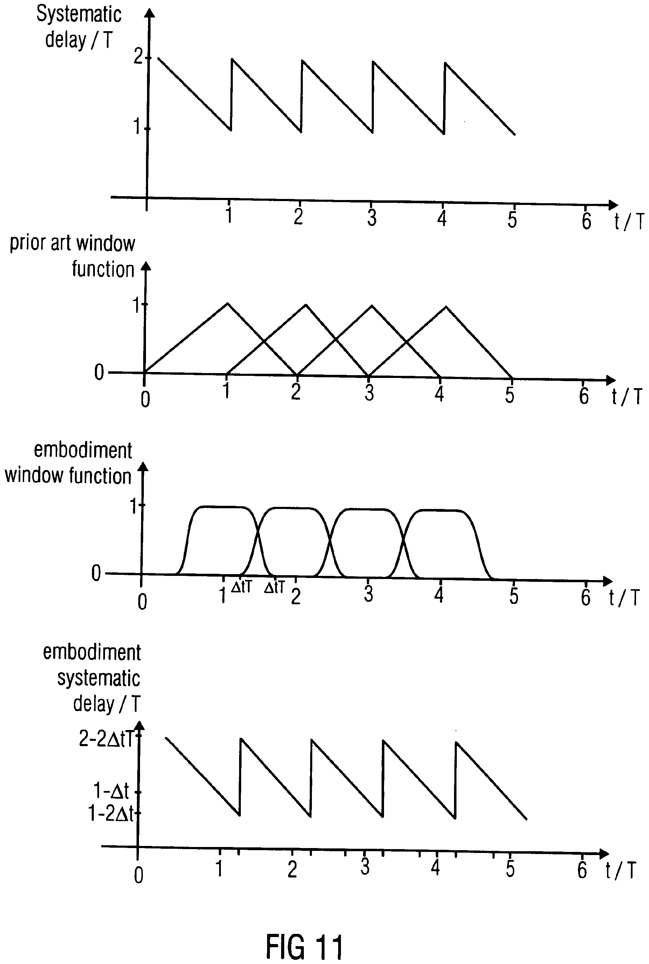

Embodiments may provide the advantage, that a systematic coding delay of the MDCT, IDMCT respectively, may be lowered when compared to the original MDCT, through application of different window functions. In order to provide more details on this advantage, Fig. 11 shows four view graph, in which the first one at the top shows a systematic delay in time units T based on traditional triangular shaped windowing functions used with MDCT, which are shown in the second view graph from the top in Fig. 11.

The systematic delay considered here, is the delay a sample has experienced, when it reaches the decoder stage, assuming that there is no delay for encoding or transmitting the samples. In other words, the systematic delay shown in Fig. 11 considers the encoding delay evoked by accumulating the samples of a frame before encoding can be started. As explained above, in order to decode the sample at T, the samples between 0 and 2T have to be transformed. This yields a systematic delay for the sample at T of another T. However, before the sample shortly after this sample can be decoded, all the samples of the second window, which is centered at 2T have to be available. Therefore, the systematic delay jumps to 2T and falls back to T at the center of the second window. The third view graph from the top in Fig. 11 shows a sequence of window functions as provided by an embodiment. It can be seen when compared to the state of the art windows in the second view chart from the top in Fig. 11 that the overlapping areas of the non-zero part of the windows have been reduced by $2\Delta t$. In other words, the window functions used in the embodiments are as broad or wide as the prior art windows, however have a first zero part and a third zero part, which becomes predictable.

In other words, the decoder already knows that there is a third zero part and therefore decoding can be started earlier, encoding respectively. Therefore, the systematic delay can be reduced by 2Δt as is shown at the bottom of Fig. 11. In other words, the decoder does not have to wait for the zero parts, which can save 2Δt. It is evident that of course after the decoding procedure, all samples have to have the same systematic delay. The view graphs in Fig. 11 just demonstrate the systematic delay that a sample experiences until it reaches the decoder. In other words, an overall systematic delay after decoding would be 2T for the prior art approach, and 2T - 2Δt for the windows in the embodiment.

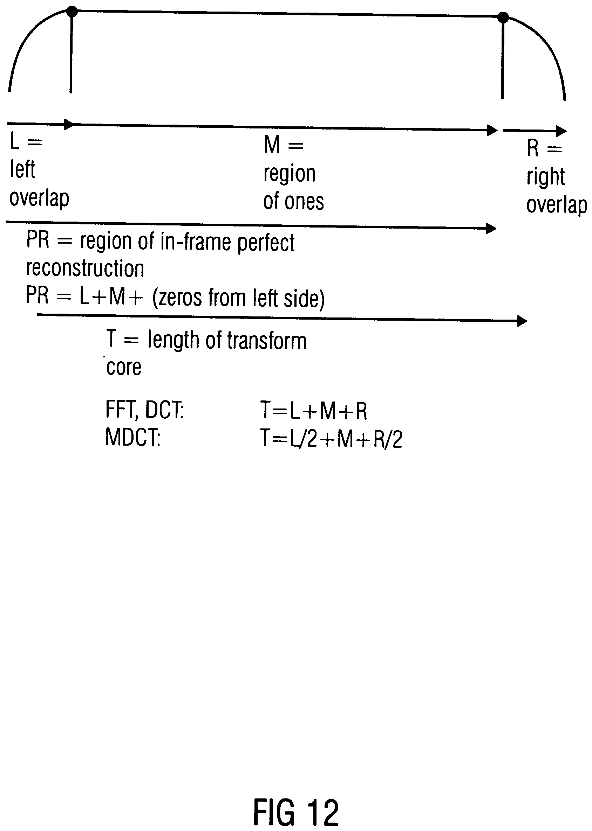

In the following an embodiment will be considered, where the MDCT is used in the AMR-WB+ codec, replacing the FFT. Therefore, the windows will be detailed, according to Fig. 12, which defines "L" as left overlap area or rising edge part, "M" the regions of ones or the second bypass part and "R" the right overlap area or the falling edge part. Moreover, the first zero and the third zero parts are considered. Therewith, a region of in-frame perfect reconstruction, which is labeled "PR" is indicated in Fig. 12 by the arrow. Moreover, "T" indicates the arrow of the length of the transform core, which corresponds to the number of frequency domain samples, i.e. half of the number of time domain samples, which are comprised of the first zero part, the rising edge part "L", the second bypass part "M", the falling edge part "R", and the third zero part. Therewith, the number of frequency samples can be reduced when using the MDCT, where the number of frequency samples for the FFT or the discrete cosine transform (DCT = Discrete Cosine Transform)

$$T = L + M + R$$

as compared to the transform coder length for MDCT

$$T = L/2 + M + R/2.$$

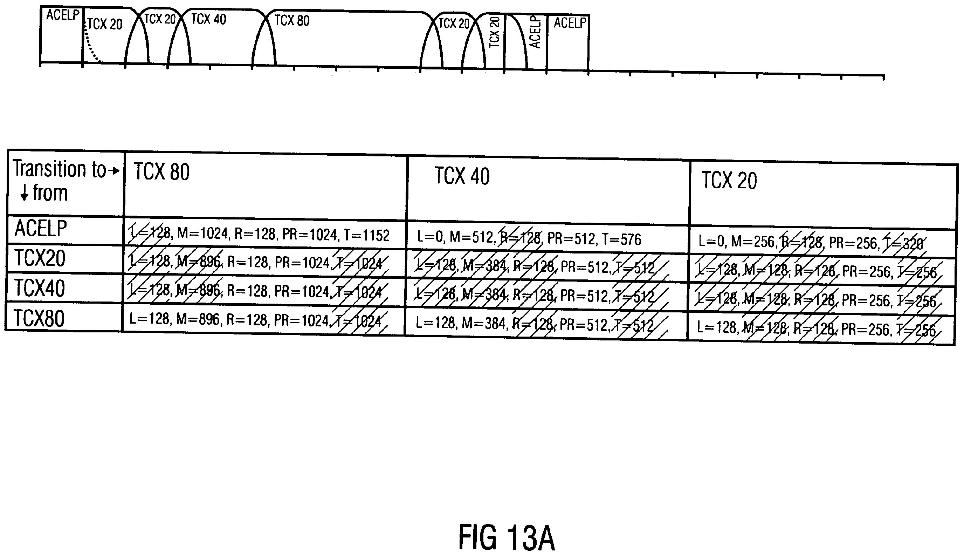

Fig. 13a illustrates at the top a view graph of an example sequence of window functions for AMR-WB+. From the left to the right the view graph at the top of Fig. 13a shows an ACELP frame, TCX20, TCX20, TCX40, TCX80, TCX20, TCX20, ACELP and ACELP. The dotted line shows the zero-input response as already described above.

At the bottom of Fig. 13a there is a table of parameters for the different window parts, where in this embodiment the left overlapping part or the rising edge part L=128 when any TCXx frame follows another TCXx frame. When an ACELP frame follows a TCXx frame, similar windows are used. If a TCX20 or TCX40 frame follows a ACELP frame, then the left overlapping part can be neglected, i.e. L=0. When transiting from ACELP to TCX80, an overlapping part of L=128 can be used. From the view graph in the table in Fig. 13a it can be seen that the basic principle is to stay in non-critical sampling for as long as there is enough overhead for an in-frame perfect reconstruction, and switch to critical sampling as soon as possible. In other words, only the first TCX frame after an ACELP frame remains non-critically sampled with the present embodiment.

In the table shown at the bottom of Fig. 13a, the differences with respect to the table for the conventional AMR-WB+ as depicted in Fig. 19 are highlighted. The highlighted parameters indicate the advantage of embodiments of the present invention, in which the overlapping area is extended such that cross-over fading can be carried out more smoothly and the frequency response of the window is improved, while keeping critically sampling.

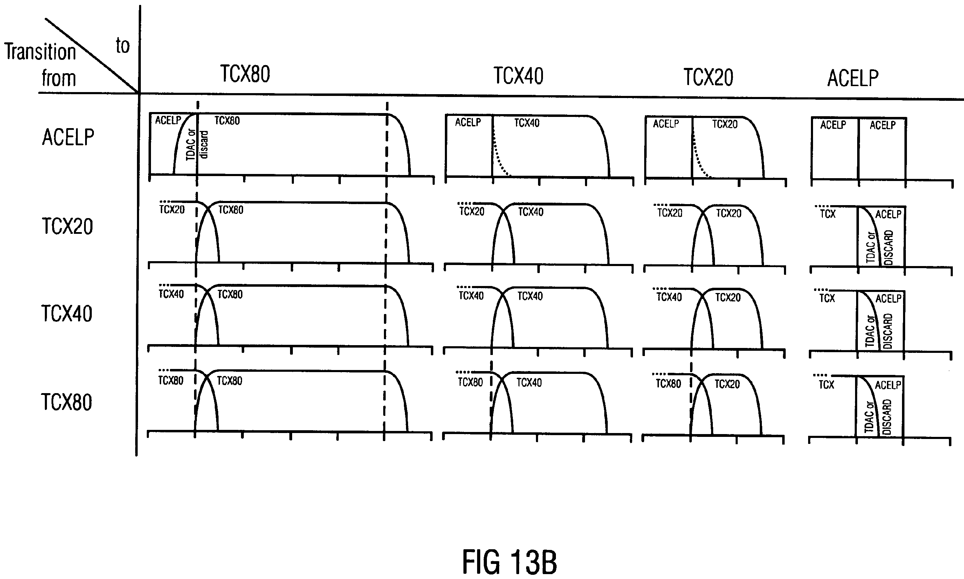

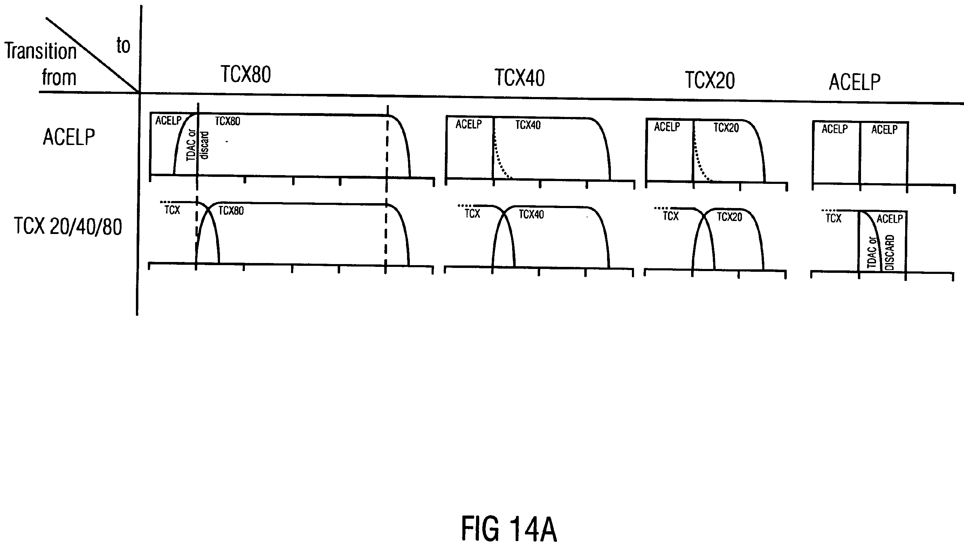

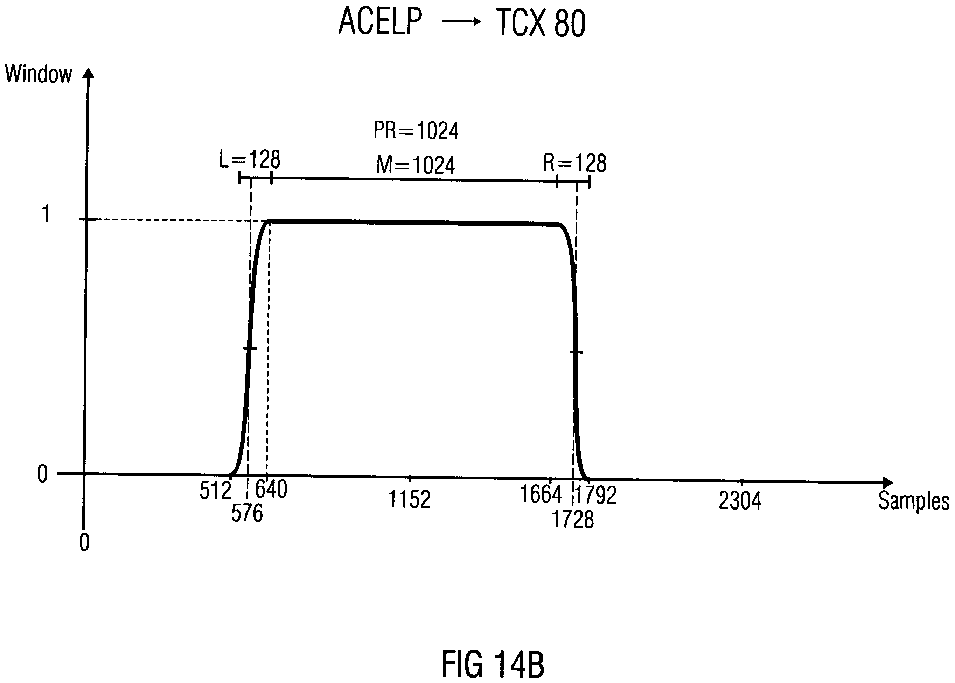

From the table at the bottom of Fig. 13a it can be seen, that only for ACELP to TCX transitions an overhead is introduced, i.e. only for this transition T>PR, i.e. non-critical sampling is achieved. For all TCXx to TCXx ("x" indicates any frame duration) transitions the transform length T is equal to the number of new perfectly reconstructed samples, i.e. critical sampling is achieved. Fig. 13b illustrates a table with graphical representations of all windows for all possible transitions with the MDCT-based embodiment of AMR-WB+. As already indicated in the table in Fig. 13a, the left part L of the windows does no longer depend on the length of a previous TCX frame. The graphical representations in Fig. 14b also show that critical sampling can be maintained when switching between different TCX frames. For TCX to ACELP transitions, it can be seen that an overhead of 128 samples is produced. Since the left side of the windows does not depend on the length of the previous TCX frame, the table shown in Fig. 13b can be simplified, as shown in Fig. 14a. Fig. 14a shows again a graphical representation of the windows for all possible transitions, where the transitions from TCX frames can be summarized in one row.

Fig. 14b illustrates the transition from ACELP to a TCX80 window in more detail. The view chart in Fig. 14b shows the number of samples on the abscissa and the window function on the ordinate. Considering the input of an MDCT, the left zero part reaches from sample 1 to sample 512. The rising edge part is between sample 513 and 640, the second bypass part between 641 and 1664, the falling edge part between 1665 and 1792, the third zero part between 1793 and 2304. With respect to the above discussion of the MDCT, in the present embodiment 2304 time domain samples are transformed to 1152 frequency domain samples. According to the above description, the time domain aliasing zone of the present window is between samples 513 and 640, i.e. within the rising edge part extending across L=128 samples. Another time domain aliasing zone extends between sample 1665 and 1792, i.e. the falling edge part of R=128 samples. Due to the first zero part and the third zero part, there is a non-aliasing zone where perfect reconstruction is enabled between sample 641 and 1664 of size M=1024. In Fig. 14b the ACELP frame indicated by the dotted line ends at sample 640. Different options arise with respect to the samples of the rising edge part between 513 and 640 of the TCX80 window. One option is to first discard the samples and stay with the ACELP frame. Another option is to use the ACELP output in order to carry out time domain aliasing cancelation for the TCX80 frame.

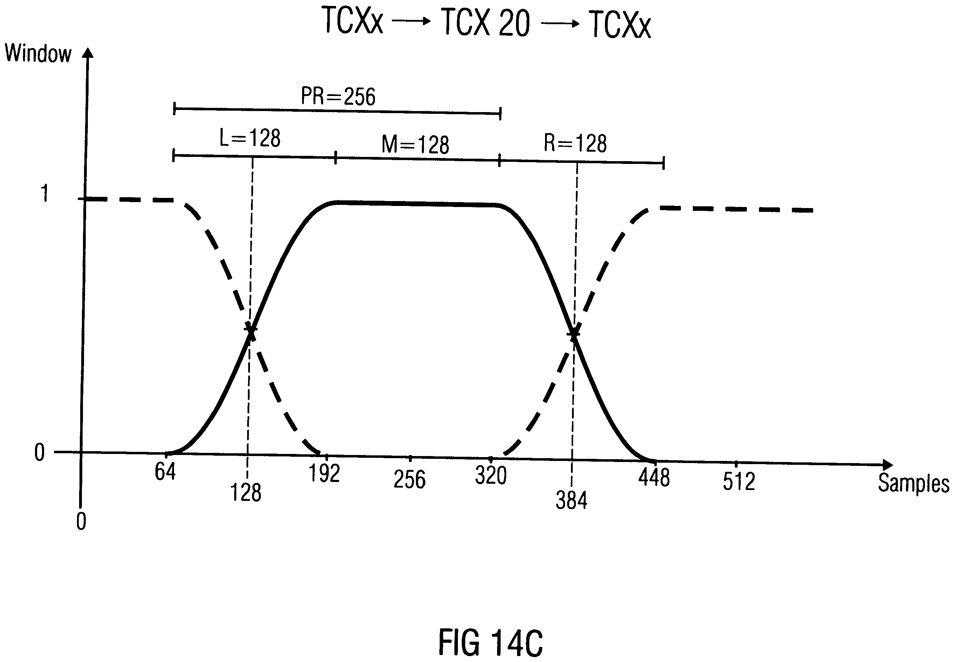

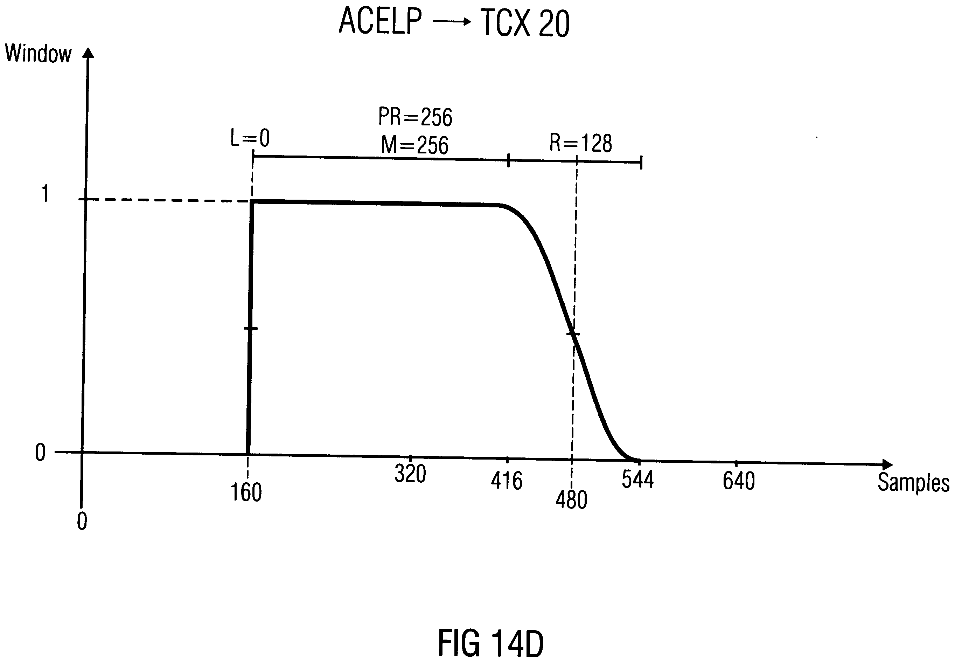

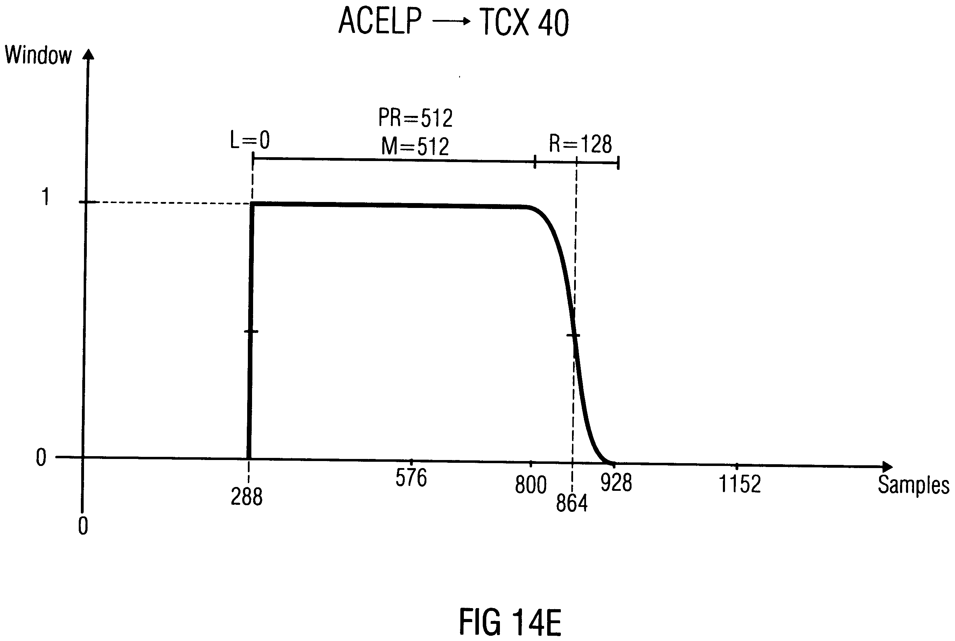

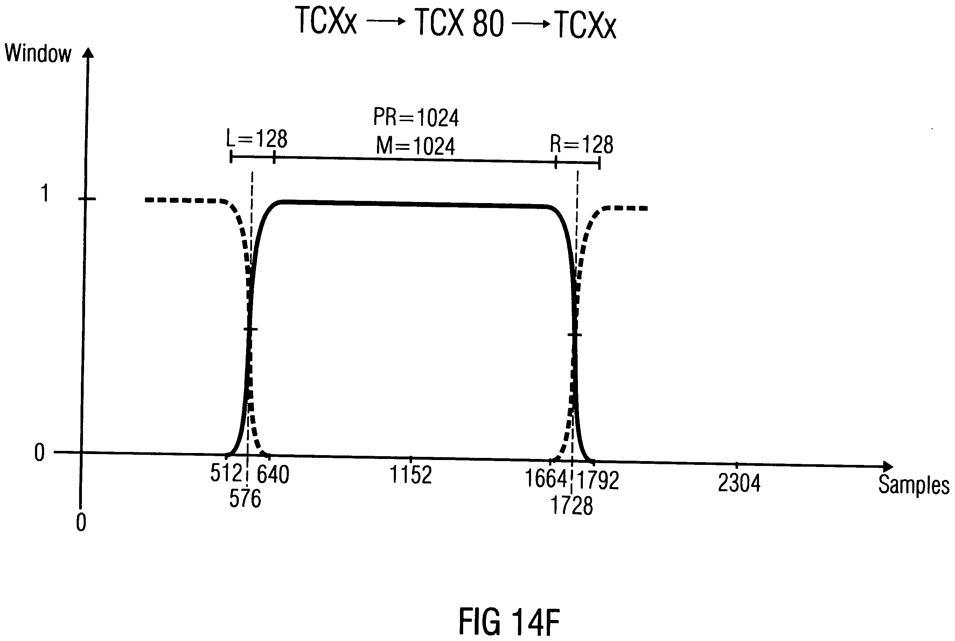

Fig. 14c illustrates the transition from any TCX frame, denoted by "TCXx", to a TCX20 frame and back to any TCXx frame. Figs. 14b to 14f use the same view graph representation as it was already described with respect to Fig. 14b. In the center around sample 256 in Fig. 14c the TCX20 window is depicted. 512 time domain samples are transformed by the MDCT to 256 frequency domain samples. The time domain samples use 64 samples for the first zero part as well as for the third zero part. Therewith, a non-aliasing zone of size M=128 extends around the center of the TCX20 window. The left overlapping or rising edge part between samples 65 and 192, can be combined for time domain aliasing cancelation with the falling edge part of a preceding window as indicated by the dotted line. Therewith, an area of perfect reconstruction yields of size PR=256. Since all rising edge parts of all TCX windows are L=128 and fit to all falling edge parts R=128, the preceding TCX frame as well as the following TCX frames may be of any size. When transiting from ACELP to TCX20 a different window may be used as it is indicated in Fig. 14d. As can be seen from Fig. 14d, the rising edge part was chosen to be L=0, i.e. a rectangular edge. Therewith, the area of perfect reconstruction PR=256. Fig. 14e shows a similar view graph when transiting from ACELP to TCX40 and, as another example; Fig. 14f illustrates the transition from any TCXx window to TCX80 to any TCXx window.

In summary, the Figs. 14b to f show, that the overlapping region for the MDCT windows is always 128 samples, except for the case when transiting from ACELP to TCX20, TCX40, or ACELP.

When transiting from TCX to ACELP or from ACELP to TCX80 multiple options are possible. In one embodiment the window sampled from the MDCT TCX frame may be discarded in the overlapping region. In another embodiment the windowed samples may be used for a cross-fade and for canceling a time domain aliasing in the MDCT TCX samples based on the aliased ACELP samples in the overlapping region. In yet another embodiment, cross-over fading may be carried out without canceling the time domain aliasing. In the ACELP to TCX transition the zero-input response (ZIR = zero-input response) can be removed at the encoder for windowing and added at the decoder for recovering. In the figures this is indicated by dotted lines within the TCX windows following an ACELP window. In the present embodiment when transiting from TCX to TCX, the windowed samples can be used for cross-fade.

When transiting from ACELP to TCX80, the frame length is longer and may be overlapped with the ACELP frame, the time domain aliasing cancelation or discard method may be used.

When transiting from ACELP to TCX80 the previous ACELP frame may introduce a ringing. The ringing may be recognized as a spreading of error coming from the previous frame due to the usage of LPC filtering. The ZIR method used for TCX40 and TCX20 may account for the ringing. A variant for the TCX80 in embodiments is to use the ZIR method with a transform length of 1088, i.e. without overlap with the ACELP frame. In another embodiment the same transform length of 1152 may be kept and zeroing of the overlap area just before the ZIR may be utilized, as shown in Fig. 15. Fig. 15 shows an ACELP to TCX80 transition, with zeroing the overlapped area and using the ZIR method. The ZIR part is again indicated by the dotted line following the end of the ACELP window.

Summarizing, embodiments of the present invention provide the advantage that critical sampling can be carried out for all TCX frames, when a TCX frame precedes. As compared to the conventional approach an overhead reduction of 1/8th can be achieved. Moreover, embodiments provide the advantage that the transitional or overlapping area between consecutive frames may always be 128 samples, i.e. longer than for the conventional AMR-WB+. The improved overlap areas also provide an improved frequency response and a smoother cross-fade. Therewith a better signal quality can be achieved with the overall encoding and decoding process.

Depending on certain implementation requirements of the inventive methods, the inventive methods can be implemented in hardware or in software. The implementation can be performed using a digital storage medium, in particular, a disc, a DVD, a flash memory or a CD having electronically readable control signals stored thereon, which cooperate with a programmable computer system such that the inventive methods are performed. Generally, the present invention is therefore a computer program product with a program code stored on a machine-readable carrier, the program code being operated for performing the inventive methods when the computer program product runs on a computer. In other words, the inventive methods are, therefore, a computer program having a program code for performing at least one of the inventive methods when the computer program runs on a computer.

**Claims**

1. An audio encoder (10) adapted for encoding frames of a sampled audio signal to obtain finally encoded frames, wherein a frame comprises a number of time domain audio samples, comprising:

   a predictive coding analysis stage (12) for determining information on coefficients of a synthesis filter and excitation frames based on frames of audio samples, an excitation frame comprising samples of an excitation signal for the synthesis filter;

a time-aliasing introducing transformer (14) for transforming overlapping excitation frames to a frequency domain to obtain excitation frame spectra, wherein the time-aliasing introducing transformer (14) is adapted for transforming the overlapping excitation frames in a critically-sampled way;

a redundancy reducing encoder (16) for encoding the excitation frame spectra to obtain encoded frames based on the coefficients and the excitation frame spectra;

a codebook encoder (13) for encoding the excitation frames based on a predetermined codebook to obtain codebook encoded excitation domain frames; and

a decider (15) for deciding whether to use a codebook encoded excitation domain frame or an encoded frame to obtain a finally encoded frame based on a coding efficiency measure.

2. The audio encoder (10) of claim 1, wherein the time-aliasing introducing transformer (14) is adapted for transforming overlapping excitation frames such that an average number of samples of an excitation frame spectrum equals the average number of samples in an excitation frame.

3. The audio encoder (10) of one of the claims 1 or 2, wherein the time-aliasing introducing transformer (14) is adapted for transforming overlapping excitation frames according to a modified discrete cosine transform (MDCT).

4. The audio encoder (10) of one of the claims 1 to 3, wherein the time-aliasing introducing transformer (14) comprises a windowing filter (17) for applying a windowing function to overlapping excitation frames and a converter (18) for converting windowed overlapping excitation frames to the excitation frame spectra.

5. The audio encoder (10) of claim 4, wherein the time-aliasing introducing transformer (14) comprises a processor (19) for detecting an event and for providing a window sequence information if the event is detected and wherein the windowing filter (17) is adapted for applying the windowing function according to the window sequence information.

6. The audio encoder (10) of claim 5, wherein the window sequence information comprises a first zero part, a second bypass part and a third zero part.

7. The audio encoder (10) of claim 6, wherein the window sequence information comprises a rising edge part between the first zero part and the second bypass part and a falling edge part between the second bypass part and the third zero part.

8. The audio encoder (10) of claim 7, wherein the second bypass part comprises a sequence of ones for not modifying the samples of the excitation frame spectra.

9. The audio encoder of one of claims 1 to 8, wherein the predictive coding analysis stage (12) is adapted for determining the information on the coefficients based on linear predictive coding (LPC).

10. The audio encoder (10) of claim 1, further comprising a switch (20) coupled to the decider (15) for switching the excitation frames between the time-aliasing introducing transformer (14) and the codebook encoder (13) based on the coding efficiency measure.

11. A method for encoding frames of a sampled audio signal to obtain finally encoded frames, wherein a frame comprises a number of time domain audio samples, comprising the steps of

determining information on coefficients for a synthesis filter based on a frame of audio samples;

determining excitation frames based on frames of audio samples, an excitation frame comprising samples of an excitation signal for the synthesis filter;

transforming overlapping excitation frames to a frequency domain to obtain excitation frame spectra in a critically-sampled way introducing time aliasing;

encoding the excitation frame spectra to obtain encoded frames based on the coefficients and the excitation frame spectra;

encoding the excitation frames based on a predetermined codebook to obtain codebook encoded excitation domain frames; and

deciding whether to use a codebook encoded excitation domain frame or an encoded frame to obtain a finally encoded frame based on a coding efficiency measure.

12. A computer program having a program code for performing the method of claim 11, when the program code runs on a computer or processor.

13. An audio decoder (80) for decoding encoded frames to obtain frames of a sampled audio signal, wherein a frame comprises a number of time domain audio samples, comprising:

a redundancy retrieving decoder (82) for decoding the encoded frames to obtain an information on coefficients for a synthesis filter and excitation frame spectra;

an inverse time-aliasing introducing transformer (84) for transforming the excitation frame spectra to the time domain to obtain overlapping excitation frames, wherein the inverse time-aliasing introducing transformer (84) is adapted for determining overlapping excitation frames from consecutive excitation frame spectra, wherein the inverse time-aliasing introducing transformer (84) further comprises a converter (84a) for converting the excitation frame spectra to converted overlapping excitation frames and a windowing filter (84b) for applying a windowing function to the converted overlapping excitation frames to obtain the overlapping excitation frames, wherein the inverse time-aliasing introducing transformer (84) comprises a processor (84c) for detecting an event and for providing a window sequence information if the event is detected to the windowing filter (84b) and wherein the windowing filter (84b) is adapted for applying the windowing function according to the window sequence information, and wherein the window sequence information comprises a first zero part, a second bypass part and a third zero part; an overlap/add combiner (86) for combing overlapping excitation frames to obtain an excitation frame in a critically-sampled way; and a predictive synthesis stage (88) for determining the frames of audio samples based on the coefficients and the excitation frame.

14. The audio decoder (80) of claim 13, wherein the overlap/add combiner (86) is adapted for combining overlapping excitation frames such that an average number of samples in an excitation frame equals an average number of samples in an excitation frame spectrum.

15. The audio decoder (80) of one of the claims 13 or 14, wherein the inverse time-aliasing introducing transformer (84) is adapted for transforming the excitation frame spectra to the time domain according to an inverse modified discrete cosine transform (IMDCT).

16. The audio decoder (80) of one of the claims 13 to 15, wherein the predictive synthesis stage (88) is adapted for determining a frame of audio samples based on linear prediction coding (LPC).

17. The audio decoder (80) of claim 13, wherein the window sequence further comprises a rising edge part between the first zero part and the second bypass part and a falling edge part between the second bypass part and the third zero part.

18. The audio decoder (80) of claim 17, wherein the second bypass part comprises a sequence of ones for modifying the samples of the excitation frame.

19. A method for decoding encoded frames to obtain frames of a sampled audio signal, wherein a frame comprises a number of time domain audio samples, comprising the steps of
decoding the encoded frames to obtain an information on coefficients for a synthesis filter and excitation frame spectra;
transforming the excitation frame spectra to the time domain to obtain overlapping excitation frames from consecutive excitation frame spectra, wherein the step of transforming comprises

converting the excitation frame spectra to converted overlapping excitation frames,
applying a windowing function, by a windowing filter (84b), to the converted overlapping excitation frames to obtain the overlapping excitation frames,
detecting an event, and providing a window sequence information if the event is detected to the windowing filter (84b),
wherein the windowing filter (84b) is adapted for applying the windowing function according to the window sequence information, and
wherein the window sequence information comprises a first zero part, a second bypass part and a third zero part;
combining overlapping excitation frames to obtain an excitation frame in a critically sampled way; and
determining the frame based on the coefficients and the excitation frame.

20. A computer program product for performing the method of claim 19, when the computer program runs on a computer or processor.

**Patentansprüche**

1. Ein Audiocodierer (10), der zum Codieren von Rahmen eines abgetasteten Audiosignals angepasst ist, um endgültig codierte Rahmen zu erhalten, wobei ein Rahmen eine Anzahl von Zeitbereichs-Audioabtastwerten aufweist, der folgende Merkmale aufweist:

eine Prädiktionscodierungs-Analysestufe (12) zum Bestimmen von Informationen über Koeffizienten eines Synthesefilters und Erregungsrahmen auf der Basis von Rahmen von Audioabtastwerten, wobei ein Erregungsrahmen Abtastwerte eines Erregungssignals für das Synthesefilter aufweist;
einen Zeit-Aliasing-einführenden Transformierer (14) zum Transformieren von überlappenden Erregungsrahmen in einen Frequenzbereich, um Erregungsrahmenspektren zu erhalten, wobei der Zeit-Aliasing-einführende Transformierer (14) angepasst ist, die überlappenden Erregungsrahmen auf eine kritisch abgetastete Weise zu transformieren;
einen Redundanzreduktionscodierer (16) zum Codieren der Erregungsrahmenspektren, um codierte Rahmen auf der Basis der Koeffizienten und der Erregungsrahmenspektren zu erhalten;
ein Codebuchcodierer (13) zum Codieren der Erregungsrahmen auf der Basis eines vorbestimmten Codebuchs, um codebuchcodierte Erregungsbereichsrahmen zu erhalten; und
einen Entscheider (15) zum Entscheiden, ob ein codebuchcodierter Erregungsbereichsrahmen oder ein codierter Rahmen verwendet werden soll, um einen endgültig codierten Rahmen auf der Basis eines Codiereffizienzmaßes zu erhalten.

2. Der Audiocodierer (10) gemäß Anspruch 1, bei dem der Zeit-Aliasing-einführende Transformierer (14) angepasst ist, überlappende Erregungsrahmen derart zu transformieren, dass eine durchschnittliche Anzahl von Abtastwerten eines Erregungsrahmenspektrums gleich der durchschnittlichen Anzahl von Abtastwerten in einem Erregungsrahmen ist.

3. Der Audiocodierer (10) gemäß einem der Ansprüche 1 oder 2, bei dem der Zeit-Aliasing-einführende Transformierer (14) angepasst ist, überlappende Erregungsrahmen gemäß einer modifizierten diskreten Cosinustransformation (MDCT) zu transformieren.

4. Der Audiocodierer (10) gemäß einem der Ansprüche 1 bis 3, bei dem der Zeit-Aliasing-einführende Transformierer (14) ein Fensterungsfilter (17) zum Anwenden einer Fensterungsfunktion auf überlappende Erregungsrahmen und einen Umwandler (18) zum Umwandeln von gefensterten überlappenden Erregungsrahmen in die Erregungsrahmenspektren aufweist.

5. Der Audiocodierer (10) gemäß Anspruch 4, bei dem der Zeit-Aliasing-einführende Transformierer (14) einen Prozessor (19) zum Erfassen eines Ereignisses und zum Bereitstellen von Fenstersequenzinformationen aufweist, falls das Ereignis erfasst ist, und bei dem das Fensterungsfilter (17) angepasst ist, die Fensterungsfunktion gemäß den Fenstersequenzinformationen anzuwenden.

6. Der Audiocodierer (10) gemäß Anspruch 5, bei dem die Fenstersequenzinformationen einen ersten Null-Teil, einen zweiten Umgehungs-Teil und einen dritten Null-Teil aufweisen.

7. Der Audiocodierer (10) gemäß Anspruch 6, bei dem die Fenstersequenzinformationen einen Ansteigende-Flanke-Teil zwischen dem ersten Null-Teil und dem zweiten Umgehungs-Teil und einen Abfallende-Flanke-Teil zwischen dem zweiten Umgehungs-Teil und dem dritten Null-Teil aufweisen.

8. Der Audiocodierer (10) gemäß Anspruch 7, bei dem der zweite Umgehungs-Teil eine Sequenz von Einsen für ein Nichtmodifizieren der Abtastwerte der Erregungsrahmenspektren aufweist.

9. Der Audiocodierer gemäß einem der Ansprüche 1 bis 8, bei dem die Prädiktionscodierungs-Analysestufe (12) zum Bestimmen der Informationen über die Koeffizienten auf der Basis einer linearen Prädiktionscodierung (LPC) angepasst ist.

10. Der Audiocodierer (10) gemäß Anspruch 1, der ferner einen Schalter (20) aufweist, der mit dem Entscheider (15) gekoppelt ist, um die Erregungsrahmen zwischen dem Zeit-Aliasing-einführenden Transformierer (14) und dem Codebuchcodierer (13) auf der Basis des Codiereffizienzmaßes umzuschalten.

11. Ein Verfahren zum Codieren von Rahmen eines abgetasteten Audiosignals, um endgültig codierte Rahmen zu erhalten, wobei ein Rahmen eine Anzahl von Zeitbereichs-Audioabtastwerten aufweist, das folgende Schritte aufweist:

Bestimmen von Informationen über Koeffizienten für ein Synthesefilter auf der Basis eines Rahmens von Audioabtastwerten;
Bestimmen von Erregungsrahmen auf der Basis von Rahmen von Audioabtastwerten, wobei ein Erregungsrahmen Abtastwerte eines Erregungssignals für das Synthesefilter aufweist;
Transformieren von überlappenden Erregungsrahmen in einen Frequenzbereich, um Erregungsrahmenspektren zu erhalten, auf eine kritisch abgetastete Weise, wobei Zeit-Aliasing eingeführt wird;
Codieren der Erregungsrahmenspektren, um codierte Rahmen auf der Basis der Koeffizienten und der codierten Erregungsrahmenspektren zu erhalten;
Codieren der Erregungsrahmen auf der Basis eines vorbestimmten Codebuchs, um codebuchcodierte Erregungsbereichsrahmen zu erhalten; und
Entscheiden, ob ein codebuchcodierter Erregungsbereichsrahmen oder ein codierter Rahmen verwendet werden soll, um einen endgültig codierten Rahmen auf der Basis eines Codiereffizienzmaßes zu erhalten.

12. Ein Computerprogramm, das einen Programmcode zum Durchführen des Verfahrens gemäß Anspruch 11 aufweist, wenn der Programmcode auf einem Computer oder Prozessor läuft.

13. Ein Audiodecodierer (80) zum Decodieren von codierten Rahmen, um Rahmen eines abgetasteten Audiosignals zu erhalten, wobei ein Rahmen eine Anzahl von Zeitbereichs-Audioabtastwerten aufweist, der folgende Merkmale aufweist:

einen Redundanzrückgewinnungsdecodierer (82) zum Decodieren der codierten Rahmen, um Informationen über Koeffizienten für ein Synthesefilter und Erregungsrahmenspektren zu erhalten;
einen inversen Zeit-Aliasing-einführenden Transformierer (84) zum Transformieren der Erregungsrahmenspektren in den Zeitbereich, um überlappende Erregungsrahmen zu erhalten, wobei der inverse Zeit-Aliasing-einführende Transformierer (84) angepasst ist, überlappende Erregungsrahmen aus konsekutiven Erregungsrahmenspektren zu bestimmen, wobei der inverse Zeit-Aliasing-einführende Transformierer (84) ferner einen Umwandler (84a) zum Umwandeln der Erregungsrahmenspektren in umgewandelte überlappende Erregungsrahmen und ein Fensterungsfilter (84b) zum Anwenden einer Fensterungsfunktion auf die umgewandelten überlappenden Erregungsrahmen aufweist, um die überlappenden Erregungsrahmen zu erhalten, wobei der inverse Zeit-Aliasing-einführende Transformierer (84) einen Prozessor (84c) zum Erfassen eines Ereignisses und zum Bereitstellen von Fenstersequenzinformationen an das Fensterungsfilter (84b) aufweist, falls das Ereignis erfasst ist, und wobei das Fensterungsfilter (84b) angepasst ist, die Fensterungsfunktion gemäß den Fenstersequenzinformationen anzuwenden, und wobei die Fenstersequenzinformationen einen ersten Null-Teil, einen zweiten Umgehungs-Teil und einen dritten Null-Teil aufweisen;
einen Überlappen/Addieren-Kombinierer (86) zum Kombinieren von überlappenden Erregungsrahmen, um einen Erregungsrahmen zu erhalten, auf eine kritisch abgetastete Weise; und
eine Prädiktionssynthesestufe (88) zum Bestimmen der Rahmen von Audioabtastwerten auf der Basis der Koeffizienten und des Erregungsrahmens.

14. Der Audiodecodierer (80) gemäß Anspruch 13, bei dem der Überlappen/Addieren-Kombinierer (86) angepasst ist, überlappende Erregungsrahmen derart zu kombinieren, dass eine durchschnittliche Anzahl von Abtastwerten in einem Erregungsrahmen gleich einer durchschnittlichen Anzahl von Abtastwerten in einem Erregungsrahmenspektrum ist.

15. Der Audiodecodierer (80) gemäß einem der Ansprüche 13 oder 14, bei dem der inverse Zeit-Aliasing-einführende Transformierer (84) angepasst ist, die Erregungsrahmenspektren gemäß einer inversen modifizierten diskreten Cosinustransformation (IMDCT) in den Zeitbereich zu transformieren.

16. Der Audiodecodierer (80) gemäß einem der Ansprüche 13 bis 15, bei dem die Prädiktionssynthesestufe (88) angepasst ist, einen Rahmen von Audioabtastwerten auf der Basis einer linearen Prädiktionscodierung (LPC) zu bestimmen.

17. Der Audiodecodierer (80) gemäß Anspruch 13, bei dem die Fenstersequenz ferner einen Ansteigende-Flanke-Teil zwischen dem ersten Null-Teil und dem zweiten Umgehungs-Teil und einen Abfallende-Flanke-Teil zwischen dem zweiten Umgehungs-Teil und dem dritten Null-Teil aufweist.

18. Der Audiodecodierer (80) gemäß Anspruch 17, bei dem der zweite Umgehungs-Teil eine Sequenz von Einsen für ein Modifizieren der Abtastwerte des Erregungsrahmens aufweist.

19. Ein Verfahren zum Decodieren von codierten Rahmen, um Rahmen eines abgetasteten Audiosignals zu erhalten, wobei ein Rahmen eine Anzahl von Zeitbereichs-Audioabtastwerten aufweist, das folgende Schritte aufweist:

Decodieren der codierten Rahmen, um Informationen über Koeffizienten für ein Synthesefilter und Erregungsrahmenspektren zu erhalten;
Transformieren der Erregungsrahmenspektren in den Zeitbereich, um überlappende Erregungsrahmen aus konsekutiven Erregungsrahmenspektren zu erhalten, wobei der Schritt des Transformierens folgende Schritte aufweist:

Umwandeln der Erregungsrahmenspektren in umgewandelte überlappende Erregungsrahmen,
Anwenden einer Fensterungsfunktion mittels eines Fensterungsfilters (84b), auf die umgewandelten überlappenden Erregungsrahmen, um die überlappenden Erregungsrahmen zu erhalten,
Erfassen eines Ereignisses und Bereitstellen von Fenstersequenzinformationen an das Fensterungsfilter (84b), falls das Ereignis erfasst ist,

wobei das Fensterungsfilter (84b) angepasst ist, die Fensterungsfunktion gemäß den Fenstersequenzinformationen anzuwenden, und

wobei die Fenstersequenzinformationen einen ersten Null-Teil, einen zweiten Umgehungs-Teil und einen dritten Null-Teil aufweisen;

Kombinieren von überlappenden Erregungsrahmen, um einen Erregungsrahmen zu erhalten, auf eine kritisch abgetastete Weise; und Bestimmen des Rahmens auf der Basis der Koeffizienten und des Erregungsrahmens.

20. Ein Computerprogrammprodukt zum Durchführen des Verfahrens gemäß Anspruch 19, wenn das Computerprogramm auf einem Computer oder Prozessor läuft.

**Revendications**

1. Codeur audio (10) adapté pour coder des trames d'un signal audio échantillonné pour obtenir des trames codées de manière définitive, dans lequel une trame comprend un nombre d'échantillons audio dans le domaine temporel, comprenant:

un étage d'analyse de codage prédictif (12) destiné à déterminer les informations sur les coefficients d'un filtre de synthèse et des trames d'excitation sur base de trames d'échantillons audio, une trame d'excitation comprenant des échantillons d'un signal d'excitation pour le filtre de synthèse;
un transformateur introduisant un repliement dans le temps (14) destiné à transformer les trames d'excitation venant en recouvrement à un domaine fréquentiel pour obtenir des spectres de trames d'excitation, où le transformateur introduisant un repliement dans le temps (14) est adapté pour transformer les trames d'excitation venant en recouvrement de manière échantillonnée de manière critique;
un codeur à réduction de redondance (16) destiné à coder les spectres de trames d'excitation pour obtenir des trames codées sur base des coefficients et des spectres de trames d'excitation;
un codeur de livre de codes (13) destiné à coder les trames d'excitation sur base d'un livre de codes prédéterminé pour obtenir des trames dans le domaine de l'excitation codées par livre de codes; et
un décideur (15) destiné à décider s'il y a lieu d'utiliser une trame dans le domaine de l'excitation codée par livre de codes ou une trame codée pour obtenir une trame codée de manière définitive sur base d'une mesure de l'efficacité de codage.

2. Codeur audio (10) selon la revendication 1, dans lequel le transformateur introduisant un repliement dans le temps (14) est adapté pour transformer les trames d'excitation venant en recouvrement de sorte qu'un nombre moyen d'échantillons d'un spectre de trames d'excitation soit égal au nombre moyen d'échantillons dans une trame d'excitation.

3. Codeur audio (10) selon l'une des revendications 1 ou 2, dans lequel le transformateur introduisant un repliement dans le temps (14) est adapté pour transformer les trames d'excitation venant en recouvrement selon une transformée cosinusoïdale discrète modifiée (MDCT).

4. Codeur audio (10) selon l'une des revendications 1 à 3, dans lequel le transformateur introduisant un repliement dans le temps (14) comprend un filtre de division en fenêtres (17) destiné à appliquer une fonction de division en fenêtres à des trames d'excitation venant en recouvrement et un convertisseur (18) destiné à convertir les trames d'excitation venant en recouvrement divisées en fenêtres en spectres de trames d'excitation.

5. Codeur audio (10) selon la revendication 4, dans lequel le transformateur introduisant un repliement dans le temps (14) comprend un processeur (19) destiné à détecter un événement et à fournir une information de séquence de fenêtres si l'événement est détecté et dans lequel le filtre de division en fenêtres (17) est adapté pour appliquer la fonction de division en fenêtres selon les informations de séquence de fenêtres.

6. Codeur audio (10) selon la revendication 5, dans lequel les informations de séquence de fenêtres comprennent une première partie de zéros, une deuxième partie de contournement et une troisième partie de zéros.

7. Codeur audio (10) selon la revendication 6, dans lequel les informations de séquence de fenêtres comprennent une partie de bord montant entre la première partie de zéros et la deuxième partie de contournement et une partie de bord descendant entre la deuxième partie de contournement et la troisième partie de zéros.

8. Codeur audio (10) selon la revendication 7, dans lequel la deuxième partie de contournement comprend une séquence de uns pour ne pas modifier les échantillons des spectres de trame d'excitation.

**9.** Codeur audio selon l'une des revendications 1 à 8, dans lequel l'étage d'analyse de codage prédictif (12) est adapté pour déterminer les informations sur les coefficients sur base d'un codage prédictif linéaire (LPC).

**10.** Codeur audio (10) selon la revendication 1, comprenant par ailleurs un commutateur (20) couplé au décodeur (15) destiné à commuter les trames d'excitation entre le transformateur introduisant un repliement dans le temps (14) et le codeur de livre de codes (13) sur base de la mesure de l'efficacité du codage.

**11.** Procédé de codage de trames d'un signal audio échantillonné pour obtenir des trames codées de manière définitive, dans lequel une trame comprend un nombre d'échantillons audio dans le domaine temporel, comprenant les étapes consistant à :

déterminer les informations sur les coefficients pour un filtre de synthèse sur base d'une trame d'échantillons audio ;
déterminer des trames d'excitation sur base de trames d'échantillons audio, une trame d'excitation comprenant des échantillons d'un signal d'excitation pour le filtre de synthèse ;
transformer les trames d'excitation venant en recouvrement à un domaine fréquentiel pour obtenir des spectres de trames d'excitation de manière échantillonnée de manière critique introduisant un repliement dans le temps ;
coder les spectres de trames d'excitation pour obtenir des trames codées sur base des coefficients et des spectres de trames d'excitation codés ;
coder les trames d'excitation sur base d'un livre de codes prédéterminé pour obtenir des trames dans le domaine de l'excitation codées par livre de codes ; et
décider s'il y a lieu d'utiliser une trame dans le domaine de l'excitation codée par livre de codes ou une trame codée pour obtenir une trame codée de manière définitive sur base d'une mesure de l'efficacité de codage.

**12.** Programme d'ordinateur présentant un code de programme pour réaliser le procédé selon la revendication 11 lorsque le code de programme est exécuté sur un ordinateur ou un processeur.

**13.** Décodeur audio (80) pour décoder des trames codées pour obtenir des trames d'un signal audio échantillonné, dans lequel une trame comprend un nombre d'échantillons audio dans le domaine temporel, comprenant :

un décodeur de récupération de redondance (82) destiné à décoder les trames codées pour obtenir une information sur les coefficients pour un filtre de synthèse et des spectres de trames d'excitation ;
un transformateur introduisant un repliement dans le temps inverse (84) destiné à transformer les spectres de trames d'excitation au domaine temporel pour obtenir des trames d'excitation venant en recouvrement, où le transformateur introduisant un repliement dans le temps inverse (84) est adapté pour déterminer les trames d'excitation venant en recouvrement de spectres de trames d'excitation successifs, dans lequel le transformateur introduisant un repliement dans le temps inverse (84) comprend par ailleurs un convertisseur (84a) destiné à convertir les spectres de trames d'excitation en trames d'excitation venant en recouvrement converties, et un filtre de division en fenêtres (84b) destiné à appliquer une fonction de division en fenêtres aux trames d'excitation venant en recouvrement converties pour obtenir les trames d'excitation venant en recouvrement, dans lequel le transformateur introduisant un repliement temporel inverse (84) comprend un processeur (84c) destiné à détecter un événement et à fournir une information de séquence de fenêtres si l'événement est détecté au filtre de division en fenêtres (84b) et dans lequel le filtre de division en fenêtres (84b) est adapté pour appliquer la fonction de division en fenêtres selon les informations de séquence de fenêtres, et dans lequel les informations de séquence de fenêtres comprennent une première partie de zéros, une deuxième partie de contournement et une troisième partie de zéros ;
un combineur de recouvrement/addition (86) destiné à combiner les trames d'excitation venant en recouvrement pour obtenir une trame d'excitation de manière échantillonnée de manière critique ; et
un étage de synthèse prédictive (88) destiné à déterminer les trames d'échantillons audio sur base des coefficients et de la trame d'excitation.

**14.** Décodeur audio (80) selon la revendication 13, dans lequel le combineur de recouvrement/ addition (86) est adapté pour combiner les trames d'excitation venant en recouvrement de sorte qu'un nombre moyen d'échantillons dans une trame d'excitation soit égal à un nombre moyen d'échantillons dans un spectre de trames d'excitation.

**15.** Décodeur audio (80) selon l'une des revendications 13 ou 14, dans lequel le transformateur introduisant un repliement dans le temps inverse (84) est adapté pour transformer les spectres de trames d'excitation au domaine temporel selon une transformée cosinusoïdale discrète modifiée inverse (IMDCT).

16. Décodeur audio (80) selon l'une des revendications 13 à 15, dans lequel l'étage de synthèse prédictive (88) est adapté pour déterminer une trame d'échantillons audio sur base d'un codage de prédiction linéaire (LPC).

17. Décodeur audio (80) selon la revendication 13, dans lequel la séquence de fenêtres comprend par ailleurs une partie de bord montant entre la première partie de zéros et la deuxième partie de contournement et une partie de bord descendant entre la deuxième partie de contournement et la troisième partie de zéros.

18. Décodeur audio (80) selon la revendication 17, dans lequel la deuxième partie de contournement comprend une séquence de uns pour modifier les échantillons de la trame d'excitation.

19. Procédé de décodage de trames codées pour obtenir des trames d'un signal audio échantillonné, dans lequel une trame comprend un nombre d'échantillons audio dans le domaine temporel, comprenant les étapes consistant à :

décoder les trames codées pour obtenir une information sur les coefficients pour un filtre de synthèse et des spectres de trames d'excitation ; transformer les spectres de trames d'excitation au domaine temporel pour obtenir des trames d'excitation venant en recouvrement de spectres de trames d'excitation successifs, où l'étape de transformation comprend le fait de

convertir les spectres de trames d'excitation en trames d'excitation venant en recouvrement converties, appliquer une fonction de division en fenêtres, par un filtre de division en fenêtres (84b), aux trames d'excitation venant en recouvrement converties pour obtenir les trames d'excitation venant en recouvrement, détecter un événement et fournir une information de séquence de fenêtres si l'événement est détecté au filtre de division en fenêtres (84b), dans lequel le filtre de division en fenêtres (84b) est adapté pour appliquer la fonction de division en fenêtres selon les informations de séquence de fenêtres, et dans lequel les informations de séquence de fenêtres comprennent une première partie de zéros, une deuxième partie de contournement et une troisième partie de zéros ;

combiner les trames d'excitation venant en recouvrement pour obtenir une trame d'excitation de manière échantillonnée de manière critique ; et déterminer la trame sur base des coefficients et de la trame d'excitation.

20. Produit de programme d'ordinateur pour réaliser le procédé selon la revendication 19 lorsque le programme d'ordinateur est exécuté sur un ordinateur ou un processeur.

**FIG 1**

A)
$$X_k = \sum_{n=0}^{2N-1} x_n \cos\left[\frac{\pi}{N}\left(n+\frac{1}{2}+\frac{N}{2}\right)\left(k+\frac{1}{2}\right)\right]$$

B)
$$y_n = \frac{1}{N}\sum_{k=0}^{N-1} X_k \cos\left[\frac{\pi}{N}\left(n+\frac{1}{2}+\frac{N}{2}\right)\left(k+\frac{1}{2}\right)\right]$$

C)
$$w_n^2 + w_{n+N}^2 = 1.$$

D)
$$w_n = \sin\left[\frac{\pi}{2N}\left(n+\frac{1}{2}\right)\right]$$

E)
$$w_n = \sin\left(\frac{\pi}{2}\sin^2\left[\frac{\pi}{2N}\left(n+\frac{1}{2}\right)\right]\right)$$

F)
$$\cos\left[\frac{\pi}{N}\left(-n-\frac{1}{2}+\frac{1}{2}\right)\left(k+\frac{1}{2}\right)\right] = \cos\left[\frac{\pi}{N}\left(n+\frac{1}{2}\right)\left(k+\frac{1}{2}\right)\right] \text{ and}$$
$$\cos\left[\frac{\pi}{N}\left(2N-n-1+\frac{1}{2}\right)\left(k+\frac{1}{2}\right)\right] = -\cos\left[\frac{\pi}{N}\left(n+\frac{1}{2}\right)\left(k+\frac{1}{2}\right)\right]$$

G)
$$\text{IMDCT(MDCT}(a,b,c,d)) = (a-b_R, b-a_R, c+d_R, c_R+d)/2$$

H)
$$(z_R,w_R)^*(z_R c + w d_R, z c_R + w_R d) = (z_R^2 c + w z_R d_R, w_R z c_R + w_R^2 d)$$

I)
$$(w,z)^*(wc - z_R d_R, zd - w_R c_R) = (w^2 c - w z_R d_R, z^2 d - w_R z c_R).$$

J)
$$(z_R^2 c + w z_R d_R, w_R z c_R + w_R^2 d) + (w^2 c - w z_R d_R, z^2 d - w_R z c_R) =$$
$$= ([z_R^2 + w^2]c + [w z_R - w z_R]d_R, [w_R^2 + z^2]d + [w_R z - w_R z]c_R) = (c,d)$$

## FIG 2

FIG 3A

EP 2 144 171 B1

FIG 3B

FIG 3C

EP 2 144 171 B1

frames of
a sampled
audio signal →

**Predictive
Coding
Analysis stage**
〜12

information on coefficients
for a synthesis filter

excitation

20

**Time-aliasing
introducing
transformer**
〜14

excitation frame
spectra

**Redundancy
Reducing
Encoder**
16〜

encoded
frames as finally
encoded frames →

**Decider**
13〜
〜15

**Codebook
Encoder**

codebook encoded
frames as finally encoded frames →

10 ↗

# FIG 3D

# Impulse – like signal segment (e.g. voice speech)

## FIG 4A

Time domain speech segment
TAPE TIME 32:14

## FIG 4B

fundamental frequency

Formant structure

EP 2 144 171 B1

FIG 5A

FIG 5B

Analysis-by-synthesis CELP

$A_L(z)$: Long Term Prediction
$\cong$ pitch (fine) structure

$A(z)$: Short Term Prediction
$\cong$ form and structure / special envelope

FIG 6

## FIG 7A

V/UV
Excitation → Glottal Model (72) → Vocal tract (70) → Spectral Cerrect. (76) → Lip Rediation (74) → Synthetic Speech

## FIG 7B

V/UV
Excitation → g (77) gain → + Σ (80) + → 78 → Synthetic Speech

79

A(z) (81)

## FIG 7C

Voiced →  * = 

time        time        time

EP 2 144 171 B1

## FIG 7D

Unvoiced ⟶

time          *          time          =          time

## FIG 7E

audio
signal

filter
determin.          783

A(z)          785

filter

Σ          786
+
−

784

prediction
error signal

10a

Short term
prediction information

EP 2 144 171 B1

EP 2 144 171 B1

encoded
frames →

| Redundancy Retrieving Decoder | excitation frame spectra → | Inverse Time-aliasing Introducing Transform | overlapping excitation frames → | Overlap / Add Combiner |

82

84

86

80 ↗

information on coefficients →

| Predictive Synthesis Stage | ← excitation frames |

88

frames →

FIG 8A

FIG 8B

FIG 8C

EP 2 144 171 B1

Bypass

second bypass part

0

first zero part

third zero part

FIG 9

FIG 10

FIG 11

L =
left
overlap

M =
region
of ones

R =
right
overlap

PR = region of in-frame perfect
reconstruction
PR = L+M+ (zeros from left side)

T = length of transform
core

FFT, DCT:       T=L+M+R

MDCT:          T=L/2+M+R/2

FIG 12

| Transition to→ ↓ from | TCX 80 | TCX 40 | TCX 20 |
|---|---|---|---|
| ACELP | L=128, M=1024, R=128, PR=1024, T=1152 | L=0, M=512, R=128, PR=512, T=576 | L=0, M=256, R=128, PR=256, T=320 |
| TCX20 | L=128, M=896, R=128, PR=1024, T=1024 | L=128, M=384, R=128, PR=512, T=512 | L=128, M=128, R=128, PR=256, T=256 |
| TCX40 | L=128, M=896, R=128, PR=1024, T=1024 | L=128, M=384, R=128, PR=512, T=512 | L=128, M=128, R=128, PR=256, T=256 |
| TCX80 | L=128, M=896, R=128, PR=1024, T=1024 | L=128, M=384, R=128, PR=512, T=512 | L=128, M=128, R=128, PR=256, T=256 |

FIG 13A

EP 2 144 171 B1

EP 2 144 171 B1

Transition from / to

| | TCX80 | TCX40 | TCX20 | ACELP |

ACELP
- ACELP / TDAC or discard / TCX80
- ACELP / TCX40
- ACELP / TCX20
- ACELP / ACELP

TCX20
- TCX20 / TCX80
- TCX20 / TCX40
- TCX20 / TCX20
- TCX / TDAC or DISCARD / ACELP

TCX40
- TCX40 / TCX80
- TCX40 / TCX40
- TCX40 / TCX20
- TCX / TDAC or DISCARD / ACELP

TCX80
- TCX80 / TCX80
- TCX80 / TCX40
- TCX80 / TCX20
- TCX / TDAC or DISCARD / ACELP

FIG 13B

FIG 14A

EP 2 144 171 B1

ACELP → TCX 80

FIG 14B

FIG 14C

TCXx → TCX 20 → TCXx

Window

PR=256

L=128    M=128    R=128

1

0

64    128    192    256    320    384    448    512    Samples

EP 2 144 171 B1

ACELP $\longrightarrow$ TCX 20

Window

PR=256
M=256

L=0

R=128

Samples

160    320    416    480    544    640

FIG 14D

46

EP 2 144 171 B1

## ACELP $\longrightarrow$ TCX 40

FIG 14E

TCXx ⟶ TCX 80 ⟶ TCXx

Window

PR=1024
L=128          M=1024          R=128

1

0

512  640          1152          1664  1792          2304          Samples
576                              1728

0

EP 2 144 171 B1

FIG 14F

ACELP

TCX80

**FIG 15**

audio in → Analysis Filterbank (1600) → Quantization & Coding (1604) → Encoding of bitstream (1606) → bitstream out

audio in → Perceptual Model (1602) → Quantization & Coding

bitstream in → Decoding of bitstream (1610) → Inverse Quantization (1620) → Synthesis Filterbank (1622) → audio out

**FIG 16A**
**(Prior Art)**

## FIG 16B (Prior Art)

## FIG 16C (Prior Art)

EP 2 144 171 B1

FIG 17A (Prior Art)

FIG 17B (Prior Art)

FIG 17C
(Prior Art)

L=
left
overlap

M=
region
of ones

R=
right
overlap

PR = region of in-frame perfect
reconstruction

T = length of transform
core

# FIG 18
# (Prior Art)

Window permanents for AMR-WB+

| Transition to→ ↓ from | TCX 80 | TCX 40 | TCX 20 |
|---|---|---|---|
| ACELP | L=0, M=1024, R=128, PR=1024, T=1152 | L=0, M=512, R=64, PR=512, T=576 | L=0, M=256, R=32, PR=256, T=288 |
| TCX20 | L=32, M=992, R=128, PR=1024, T=1152 | L=32, M=480, R=64, PR=512, T=576 | L=32 M=224, R=32, PR=256, T=288 |
| TCX40 | L=64, M=960, R=128, PR=1024, T=1152 | L=64, M=448, R=64, PR=512, T=576 | L=64, M=192, R=32, PR=256, T=288 |
| TCX80 | L=128, M=896, R=128, PR=1024, T=1152 | L=128, M=384, R=64, PR=512, T=576 | L=128, M=128, R=32, PR=256, T=288 |

FIG 19
(Prior Art)

EP 2 144 171 B1

FIG 20
(Prior Art)

**EP 2 144 171 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **B. EDLER ; G. SCHULLER.** Audio coding using a psychoacoustic pre- and post-filter. *ICASSP 2000,* June 2000, vol. 2 (5-9
- Perceptual Audio Coding using Adaptive Pre- and Post-Filters and Lossless Compression. **G. SCHULLER ; B. YU ; D. HUANG ; B. EDLER.** Transactions on Speech and Audio Processing. IEEE, September 2002, 379-390
- **M. KARJALAINEN ; A. HÄRMÄ ; U.K. LAINE.** Realizable warped IIR filters and their properties. *IEEE ICASSP,* 1997, vol. 3, 2205-2208
- **J.O. SMITH ; J.S. ABEL.** Bark and ERB Bilinear Trans-forms. *IEEE Transactions on Speech and Audio Processing,* November 1999, vol. 7 (6), 697-708
- **S. WABNIK ; G. SCHULLER ; U. KRÄMER ; J. HIRSCHFELD.** Frequency Warping in Low Delay Audio Coding. *IEEE International Conference on Acoustics, Speech, and Signal Processing,* 18 March 2005
- **HÄRMÄ AKI ; KARJALAINEN MATTI ; SAVIOJA LAURI ; VÄLIMÄKI VESA ; LAINE UNTO K. ; HUOPANIEMI JYRI.** Frequency-Warped Signal Processing for Audio Applications. *Journal of the AES,* November 2000, vol. 48 (11), 1011-1031
- **E. SCHUIJERS ; W. OOMEN ; B. DEN BRINKER ; J. BREEBAART.** Advances in Parametric Coding for High-Quality Audio. *114th Convention,* 2003
- Speech coding based on adaptive melcepstral analysis. **K. TOKUDA ; H. MATSUMURA ; T. KOBAYASHI ; S. IMAI.** Proc. IEEE ICASSP'94. April 1994, 197-200
- **K. KOISHIDA ; K. TOKUDA ; T. KOBAYASHI ; S. IMAI.** CELP coding based on melcepstral analysis. *Proc. IEEE ICASSP'95,* 1995, 33-36
- **AKI HÄRMÄ ; UNTO K. LAINE ; MATTI KARJALAINEN.** Warped low-delay CELP for wideband audio coding. *17th International AES Conference,* 1999
- **B. BESSETTE ; R. LEFEBVRE ; R. SALAMI.** UNIVERSAL SPEECH/AUDIO CODING USING HYBRID ACELP/TCX TECHNIQUES. *Proc. IEEE ICASSP 2005,* 2005, 301-304
- **S.A. RAMPRASHAD.** A Multimode Transform Predictive Coder (MTPC)for Speech and Audio. *IEEE workshop on speech coding proceedings, module, coders and error criteria,* 1999, 10-12
- **ANDREAS SPANIERS.** Speech Coding: A tutorial review. *Proceedings of IEEE,* October 1994, vol. 84 (10), 1541-1582

56